# EUROPEAN PATENT SPECIFICATION

(11) **EP 4 012 771 B1**
(45) Date of publication and mention of the grant of the patent: **28.05.2025**
(21) Application number: 21197032.2
(22) Date of filing: 16.09.2021
(51) Int. Cl.: H10B 63/00

(54) **DECK SELECT TRANSISTOR FOR THREE-DIMENSIONAL CROSS-POINT MEMORY**
EBENENAUSWAHLTRANSISTOR FÜR EINEN DREIDIMENSIONALEN KREUZPUNKTSPEICHER
TRANSISTOR DE SÉLECTION DE PLAN POUR MÉMOIRE À POINTS DE CROISEMENT TRIDIMENSIONNELLE

(30) Priority: 10.12.2020 US 202017118377
(43) Date of publication of application: 15.06.2022
(73) Proprietor: Intel Corporation, Santa Clara, CA 95054 (US)
(72) Inventor: Majhi, Prashant, San Jose, 95121 (US); Kau, Derchang, Cupertino, 95014 (US); Hineman, Max, Boise, 83702 (US)
(74) Representative: Goddar, Heinz J.

(56) References cited:
- US-A1- 2013 134 372
- US-A1- 2014 284 535
- US-A1- 2015 162 380

## Description

### BACKGROUND

A three-dimensional (3-D) cross point memory array may have tiers, or decks, of memory cells. However, increasing a total number of memory cells in this manner may proportionately increase the number of decoder transistors needed, thereby increasing an overall footprint of the decoder transistors. As such, solutions are required to increase memory density while minimizing decoder transistor footprint.

Each of US 2015/162380 A1, US 2014/284535 A1 and US 2013/134372 A1 discloses a memory device structure according to the preamble of claim 1.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements.
**Figure 1** is an isometric illustration of a memory device structure, where the memory device structure includes a plurality of transistors, in accordance with an embodiment of the present invention.
**Figure 2A** is an isometric illustration of a portion of the memory device structure in **Figure 1****,** in accordance with an embodiment of the present invention.
**Figure 2B** is a cross-sectional illustration through a line structure in **Figure 2A****.**
**Figure 2C** is a cross-sectional illustration through a line orthogonal to the line structure in **Figure 2A****.**
**Figure 2D** is a cross-sectional illustration of a gated portion of the line structure in **Figure 2A****.**
**Figure 3A** is an isometric illustration of a portion of the memory device structure in **Figure 1****,** in accordance with another embodiment of the present invention.
**Figure 3B** is a cross-sectional illustration of a line structure in **Figure 3A****.**
**Figure 3C** is a cross-sectional illustration of a gated portion of the line structure in **Figure 3A****.**
**Figure 4A** is an isometric illustration of a portion of the memory device structure in **Figure 1****,** in accordance with yet another embodiment of the present invention.
**Figure 4B** is a cross-sectional illustration of a line structure in **Figure 4A****.**
**Figure 4C** is a cross-sectional illustration of a gated portion of the line structure in **Figure 4A****.**
**Figure 4D** is a cross-sectional illustration through a line orthogonal to the line structure in **Figure 4A****.**
**Figure 5A** is a cross-sectional illustration of a structure of the memory device through a line A-A' in **Figure 1****.**
**Figure 5B** is a cross sectional illustration of a memory cell used in embodiments of the present invention.
**Figure 5C** is a cross sectional illustration of a non-volatile memory element of a memory cell used in embodiments of the present invention.
**Figure 5D** is a cross sectional illustration of another non-volatile memory element of a memory cell used in embodiments of the present invention.
**Figure 5E** is a cross sectional illustration of a selector element of a memory cell used in embodiments of the present invention.
**Figure 6** is a method to fabricate a device structure such as device structure described in association with **Figure 2A****,** **3A** **or** **4A****.**
**Figure 7A** is a cross-sectional illustration of plurality of interconnects patterned in a dielectric above a substrate.
**Figure 7B** is an isometric illustration of the structure in **Figure 7A****.**
**Figure 8A** illustrates the structure of **Figure 7A** following the formation of a plurality of line segments above the substrate.
**Figure 8B** is an isometric illustration of the structure in **Figure 8A****.**
**Figure 9** illustrates the structure of **Figure 8B** following the formation of a dielectric in between each of the plurality of line segments to form a block.
**Figure 10A** illustrates the structure of **Figure 9** following the process of etching portions of the block.
**Figure 10B** is a cross-sectional illustration of a line structure in **Figure 10A****.**
**Figure 11A** illustrates the structure of **Figure 10A** following the formation of a thin filmchannel (TF-Channel) material over a plurality of line structure.
**Figure 11B** is a cross-sectional illustration through a plurality of line structures.
**Figure 12A** is a cross-sectional illustration of the structure in **Figure 11B** following the process to remove portions of the channel material between portions of adjacent line structures.
**Figure 12B** is a cross-sectional illustration of the structure in **Figure 11B** following the process to remove portions of the channel material from above the line structure.
**Figure 13A** illustrates the structure of **Figure 11B** following the formation of a gate dielectric layer 1300.
**Figure 13B** is a cross-sectional illustration through a plurality of line structures in **Figure 13A****.**
**Figure 14A** illustrates the structure of **Figure 13A** following the formation of a gate electrode.
**Figure 14B** is a cross-sectional illustration of gate electrodes over a plurality of line structures in **Figure 14A****.**
**Figure 15A** illustrates the structure of **Figure 9****,** where an ALD deposition process is utilized to selectively deposit TFT channel material around a portion of line structures.
**Figure 15B** is a cross-sectional illustration of a gate electrode around a line structure in **Figure 15A****.**
**Figure 16A** illustrates the structure of **Figure 9** following the formation of a plurality of openings.
**Figure 16B** illustrates the structure of **Figure 16A** following the formation of a sacrificial dielectric in each of the plurality of openings, on the dielectric 702 followed by the formation of a channel layer 1606 on the dielectric 1604.
**Figure 16C** illustrates the structure of **Figure 16D** following a process to reduce the height of the channel.
**Figure 16D** illustrates the structure of **Figure 16C** following the formation of a gate dielectric layer.
**Figure 16E** illustrates the structure of **Figure 16D** following the formation of a gate electrode on the gate dielectric layer.
**Figure 16F** illustrates the structure of **Figure 16E** following the process to remove portions of gate dielectric layer.
**Figure 16G** illustrates the structure of **Figure 16F** following the formation of source structure adjacent to each channel.
**Figure 17** is an isometric illustration of a system where a memory device structure is coupled by a number of logic transistors and peripheral components.
**Figure 18** is a block diagram of an example of a computing system that includes a deck select transistor array coupled with a memory device array to enable decoder transistor footprint scaling.
**Figure 19** is a block diagram of an example of a mobile device that includes a deck select transistor array coupled with a memory device array to enable decoder transistor footprint scaling.

### DESCRIPTION OF THE EMBODIMENTS

Deck select transistors for 3-Dimensional (3-D) cross point and methods of fabrication are described. In the following description, numerous specific details are set forth, such as structural schemes and detailed fabrication methods in order to provide a thorough understanding of embodiments of the present invention. It will be apparent to one skilled in the art that embodiments of the present invention may be practiced without these specific details. In other instances, well-known features, such as operations associated with memory devices and transistors, are described in lesser detail in order to not unnecessarily obscure embodiments of the present invention. Furthermore, it is to be understood that the various embodiments shown in the figures are illustrative representations and are not necessarily drawn to scale.

In some instances, in the following description, well-known methods and devices are shown in block diagram form, rather than in detail, to avoid obscuring the present disclosure. Reference throughout this specification to "an embodiment" or "one embodiment" or "some embodiments" means that a particular feature, structure, function, or characteristic described in connection with the embodiment is included in at least one embodiment of the invention. Thus, the appearances of the phrase "in an embodiment" or "in one embodiment" or "some embodiments" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical, electrical or in magnetic contact with each other, and/or that the two or more elements co-operate or interact with each other (e.g., as in a cause an effect relationship).

The terms "over," "under," "between," and "on" as used herein refer to a relative position of one component or material with respect to other components or materials where such physical relationships are noteworthy. For example, in the context of materials, one material or material disposed over or under another may be directly in contact or may have one or more intervening materials. Moreover, one material disposed between two materials may be directly in contact with the two layers or may have one or more intervening layers. In contrast, a first material "on" a second material is in direct contact with that second material/material. Similar distinctions are to be made in the context of component assemblies. As used throughout this description, and in the claims, a list of items joined by the term "at least one of" or "one or more of" can mean any combination of the listed terms.

The term "adjacent" here generally refers to a position of a thing being next to (e.g., immediately next to or close to with one or more things between them) or adjoining another thing (e.g., abutting it).

The term "signal" may refer to at least one current signal, voltage signal, magnetic signal, or data/clock signal. The meaning of "a," "an," and "the" include plural references. The meaning of "in" includes "in" and "on."

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

As used throughout this description, and in the claims, a list of items joined by the term "at least one of" or "one or more of" can mean any combination of the listed terms.

Unless otherwise specified in the explicit context of their use, the terms "substantially equal," "about equal" and "approximately equal" mean that there is no more than incidental variation between two things so described. In the art, such variation is typically no more than +/-10% of a predetermined target value.

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

Memory cells are used in conjunction with large arrays of decoder transistors for a variety of 3-D cross point memory applications. A 3-D cross point memory array includes a series of word lines on a first plane and series of bit lines on a second plane above the first plane, where the word lines cross over the bit lines (or vice versa). A memory cell is located at each point of cross over (cross-point) between the word line and the bit line, where the memory cell couples a word line with a corresponding bit line to form a single memory array deck, or herein deck.

A decoder transistor may be individually coupled with each word line and a bit line to address a particular memory cell in a deck. A number of decoder transistors required to address each memory cell (bit cell) is proportional to the number of memory cells in a 3-D cross point array. The number can increase in proportion with increase in number of bit lines and word lines. To accommodate a larger number of decoder transistors in a vicinity of a cross point array, such as, for example below the 3-D cross-point memory array, physical lengths of word lines and bit line may be increased. Alternatively, decoder transistors may occupy a region laterally adjacent to the memory array. In either example a larger chip area may be utilized.

Increasing number of layers (decks) of memory cells to form a 3 -dimensional array can increase memory density per unit area. However, increasing the number of memory cells also proportionately increases the number of decoder transistors required. In some examples a single deck may include 8K bit lines and 8K word lines. Thus, a single 8K by 8K deck can require 16K decoder transistors. Because the number of decoder transistors increases proportionally with the number of decks, enabling a high-density memory array for a given die size can be highly challenging.

However, the inventors have devised an arrangement that can reduce the number of number of decoder transistors below a 3-D cross point memory array by integrating a deck select transistor within each word line and each bit line of a deck. Additionally, vertically spaced word lines (and bit lines) across multiple decks are collectively coupled together. In one example, a memory array may include two decks, where each word line of a first deck is coupled with a corresponding word line of a second deck directly below by an interconnect via. Each pair of word lines is coupled by a single decoder transistor below the memory array. For example, a first interconnect via can be used to couple the pair of word lines and a second interconnect via can couple the lowest word line to a decoder transistor. As the number of decks are increased, respective word lines from each successive deck may be coupled together by an intervening interconnect via. A lowest word line corresponding to a lowest level deck may be further coupled to a single decoder transistor below the lowest deck.

Similarly, each bit line of a first deck may be coupled with a corresponding bit line of a second deck directly below by an interconnect via. Each pair of bit lines is coupled to a single decoder transistor by an interconnect via. When the number of decks are increased, a respective bit line from each successive deck are coupled to each other and to a single decoder transistor. For example, a first bit line from a first deck may be coupled with a first bit line from a second deck directly above the first bit line. Thus, the total number of decoder transistors in a memory array is equal to a total number of word and bit lines on any given deck, and independent of the number of decks. During operation, while all word lines (bit lines) that are coupled across multiple decks may be biased simultaneously. However, because there is an intervening deck select transistor between the memory cell and the interconnect via on each deck, it is possible to select a single memory cell to program by biasing an appropriate deck select transistor.

When each deck include a large number of word lines and bit lines (8K for example), turning on each deck select transistor will require a large number of routing lines. To mitigate the problem of individually routing each transistor, gates of each deck select transistor on each of the word lines (bit line) of a single deck may be electrically coupled together. A single routing conductor may be coupled with a single deck select transistor. During operation, all deck select transistors on word lines (bit lines) of a single deck will be at a same gate bias. However, a single deck select transistor and a single word line-bit line combination may be biased to program a single memory cell.

In a first deck select transistor embodiment, each word line (bit line) includes a line portion that is fully oxidized (herein, oxidized line portion) to form an electrical break and a channel material is adjacent to at least one sidewall of the oxidized line portion. In some such embodiments, a gate structure is adjacent to the channel material and the immediate conductive portions of the word line (or bit line) on either side of the oxidized line portion may function as source or drain regions of the deck select transistor. In some embodiments, the channel material completely clads the oxidized line portion, and the gate structure clads the channel material. In exemplary embodiments, the transistors are thin film transistors that include an amorphous or polycrystalline channel.

In a second deck select transistor embodiment, each word line (bit line) is divided into co-linear two conductive line segments with a channel material (also colinear) between and colinear with the two conductive line segments. The two conductive line segments on either side of the channel material may function as source or drain regions of the second deck select transistor embodiment. In some such embodiments, a gate structure is adjacent to two or more surfaces of the channel material. In an exemplary embodiment, the gate structure is on three surfaces (e.g., on a top surface and on two sidewall surfaces) of the channel material and the deck select transistor is a fin-FET device.

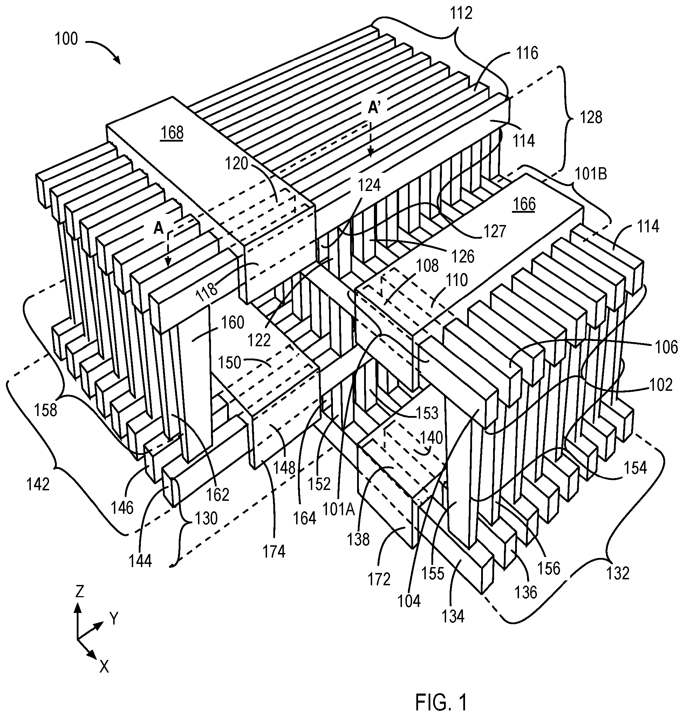

**Figure 1** is an isometric illustration of a memory device structure 100 according to an embodiment of the present invention, including deck select transistors, such as deck select transistor 101A and 101B. Memory device structure 100 includes a first line structure 102 (herein line structure 102) along a first direction (for e.g., x-axis). The line structure 102 includes a line 104 (herein line 104) adjacent to a line structure 106 (herein line 106), where the line 104 includes a channel 108 and line 106 includes a transistor channel 110. The memory device structure 100 further includes a second plurality of line structures 112 (herein line structure 112) along a second direction (e.g., y-axis). As shown, line structure 112 is directed along the y-axis. Line structure 112 includes line 114 adjacent to a line 116, where the line 114 includes a transistor channel 118 and the line 116 includes a transistor channel 120.

The memory device structure 100 further includes a memory cell at each cross-point between the line structures 102 and the line structures 112. The total number of memory cells per deck is equivalent to a product of the number of lines in line structures 112 and the number of lines in line structure 112. The memory device structure 100 includes 64 memory cells on a single deck, as shown. Examples of memory device structure 100 includes a memory cell 122 at a cross point between line 104 and line structure 114, a memory cell 124 at a cross point between line 104 and line 116, a memory cell 126 at an intersection between line 106 and line structure 114, for example.

The memory device structure 100 includes multiple layers of line structures such as line structures 102 and 112. Each pair of line structures such as line structures 102 and 112 that are separated by an array of memory cells, such as memory cell array 127, constitutes a memory deck. The lines in line structures 102 and 112 operate as multiple word and bit line pairs, respectively (or vice versa). In the illustrative embodiment, the memory structure 100 includes 3 decks. A first deck 128 includes line structures 102 and 112, and memory cell array 127.

In the illustrative embodiment, memory device structure 100 further includes a second deck 130 below the deck 128. The deck 130 includes a plurality of line structures 132 (herein line structure 132) parallel to the line structure 112. The line structure 132 includes a line 134 and a line 136, where line 134 includes a transistor channel 138 and the line 134 includes a transistor channel 140. The lines in line structure 132 and in line structure134 operate as multiple word and bit line pairs, respectively (or vice versa).

The memory device structure 100 further includes a plurality of line structures 142 (herein line structure 142) parallel to the line structure 112. In the Figure, the line structure 142 has a longitudinal axis along the y-axis. The line structure 142 includes line structure 144 adjacent to a line structure 146, where the line 144 includes a transistor channel 148 and the line 146 includes a transistor channel 150. The deck 130 further includes a memory cell, at each cross-point between the line structure 132 and the line structure 142. As shown, memory cell 152 is at a cross-point between line structures 134 and 144 and memory cell 153 is at a cross point between line structures 134 and 144.

In the illustrative embodiment, the memory device structure 100 includes an array of 8 by 8 orthogonal lines per deck. Depending on embodiments, deck 128 or 130 can include between 2000-8000 lines.

Each deck select transistor, for example, transistor 101A includes a gate electrode adjacent to the channel and an intervening gate dielectric layer between the gate electrode and the channel. In the illustrative embodiment, individual gate electrodes of each deck select transistor, e.g., transistors 101A and 101B are coupled together. As shown gate structure 166 includes gate electrodes of adjacent transistor channels in each line of line structure 102. The gate dielectric layer isolates each channel layer of each deck select transistor (101A, 101B etc) in the line structure 102. In embodiments, coupling between gate electrodes of distinct deck select transistors 101A, 101B etc. advantageously enables simultaneous biasing of gate electrodes, saving significant real estate for other essential circuitry. In an embodiment, where lines structure 102 includes 8000 lines, all 8000 gate electrodes may be coupled by a single routing conductor.

The memory device structure 100 further includes gate structures 168, 172 and 174 adjacent to a plurality of transistor channels. Gate structure 168, 172 and 174 include one or more features of the gate structure 166 such as a gate electrode and a gate dielectric layer. It is to be appreciated that each gate structure 166, 168, 172 and 174 may be independently biased through one or more biasing electrodes (not shown in the Figure).

Memory device structure 100 may include different deck select transistor architectures including different gate and channel structures having different FET characteristic ( for e.g., N-FET a P-FET)

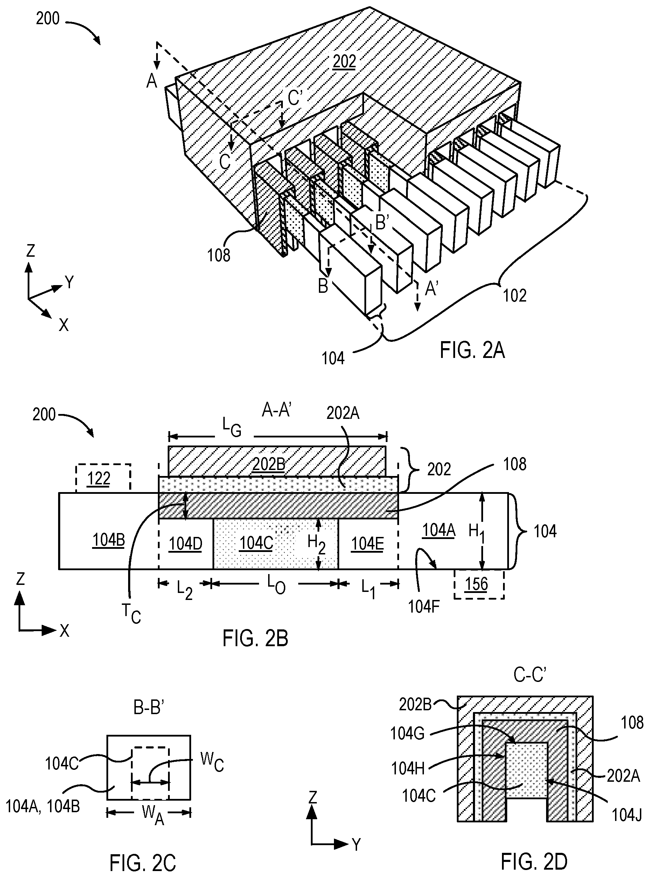

**Figure 2A** is an isometric illustration of a deck select deck select transistor 200 in accordance with embodiments of the present invention. Portions of the channel 108 are removed to provide clarity. As shown, each line structure in the line structure 102 has various portions that have varying material compositions along a longitudinal length (e.g., x-axis). In the illustrative embodiment, each line in line structure 102 also has a cross-sectional area in the y-z plane that varies along the x-direction in regions within channel 108. A portion of gate structure 202 and channel 108 is cut out to reveal a shape of a representative line, for example line 104 and channel, for example channel 108. In an embodiment, the gate structure 202 includes a gate dielectric layer, and a gate electrode. In the illustrative embodiment, a gate dielectric layer is not shown for clarity. As shown, gate structure 202 is adjacent to each transistor channel in each line of the line structure 102.

**Figure 2B** is a cross sectional illustration of deck select transistor 200 through the line A-A' in the structure of **Figure 2A****.** In the illustrative embodiment, line 104 has a line portion 104A and a line portion 104B that includes a metal or an alloy including the metal, and a line portion 104C between line portion 104A and line portion 104B. In an embodiment, line portion 104C includes the metal and oxygen. The deck select transistor 200 includes channel 108, and gate structure 202 on the channel 108. As shown, gate structure 202 includes a gate dielectric layer 202A on the channel 108 and a gate electrode 202B on the gate dielectric layer 202A. In the illustrative embodiment, line portion 104A is a source or a drain region and line portion 104B is a drain or a source region of the deck select transistor 200. In the illustrative embodiment, terminal interconnect is coupled with line portion 104B and memory cell 122 is on and coupled with line portion 104B. Only one memory cell is shown, though line portion 104B is long enough to include multiple memory cells as shown in **Figure 1****.** Referring again to **Figure 2B****,** The entire line portion 104B may be considered to be a source or a drain, as the line portions 104A and 104B are conductive.

Line portion 104C is insulative and has a length, L_{O}, along the x-axis. In some embodiments, L_{O} is between 10 nm and 500 nm. The length of line portion 104C determines a maximum effective gate length, L_{G} of deck select transistor 200.

In the illustrative embodiment, line 104 also includes a line portion 104D between line portions 104B and 104C. Line portion 104D may have a same or substantially the same material composition as line portion 104B. As shown, line 104 also includes a portion 104E between line portions 104A and 104C. Line portion 104E has a same or substantially the same material composition as a material composition of line portion 104A or 104B. Line portions 104D and 104E may be considered to be lateral source or drain extensions under the channel 108. In some embodiments the line structure portion 104A, 104D and 104E include a metal such as tungsten, tantalum or titanium. In other embodiments line structure portion 104A, 104D and 104E include nitrogen and at least one of tungsten tantalum or titanium.

As shown, line portions 104D and 104E have a length, L₁ and L₂, respectively. In some embodiments, , L₁ and L₂, range between 10 nm and 100 nm and 10 nm and 100 nm, respectively. L₁ may be equal to or be different than L₂.

As shown, line 104 has a height relative to a lower most surface 104F that varies along the x-direction. In the illustrative embodiment, the height of line 104 decreases in the vicinity of channel 108 compared to away from the channel 108. As shown line portions 104A and 104B have a height, H₁. In embodiments, H₁ is between 15 nm and 100 nm. As shown portions 104C, 104D and 104E have a height, H₂ that is less than H₁. In embodiments, H₂ is between 10 nm and 95 nm. In exemplary embodiments, H₂ is substantially uniform along the x-axis.

In the illustrative embodiment, the channel 108 extends laterally beyond line portion 104C along the x-axis, and over line portions 104D and 104E. Channel 108 has a thickness, T_{C}. In the illustrative embodiment, the channel 108 has a thickness, T_{C} that is substantially equal to a difference between respective heights of the line portions 104A and line portion 104C, 104D or 104E. In other embodiments T_{C} is greater or less than a difference between respective heights of the line portions 104A and line portion 104C, 104D or 104E.

The gate structure 202 has a gate length that is less than a lateral width of the channel 108 (L_{effective} of deck select transistor 200). In embodiments, L_{G}, is between 50 nm and 600 nm. In the illustrative embodiment, the gate structure 202 does not extend over the line portions 104A and 104B.

In an embodiment, the gate electrode 202 includes at least one P-type work function metal or an N-type work function metal, depending on whether a transistor is to be a P-FET or an N-FET transistor. Examples of N type material include hafnium, zirconium, titanium, tantalum, aluminum, alloys of these metals, and carbides of these metals such as hafnium carbide, zirconium carbide, titanium carbide, tantalum carbide, or aluminum carbide and examples of P type materials include ruthenium, palladium, platinum, cobalt, nickel, or conductive metal oxides, e.g., ruthenium oxide.

In embodiments, the gate dielectric layer 202A includes a material having a high dielectric constant or high-K material. Examples of gate dielectric layer 202A include oxygen and one or more of elements such as hafnium, silicon, titanium, tantalum, lanthanum, aluminum, zirconium, barium, strontium, yttrium, lead, scandium, niobium, or zinc. Examples of high-K material that may be used in the gate dielectric layer 202A include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

In some embodiments gate structure 202 includes one or more work function layers (gate electrode 202B), and a fill metal on the one or more work function layers, where the fill metal (not shown in illustration) fills a space between gate electrodes of respective adjacent lines. In some such embodiments, gate structure 202 includes a layer of additional conductive material extending above gate electrode 202B.

**Figure 2C** is a cross illustration of the line portion 104A or 104B. In the illustrative embodiment, an outline of the line portion 104C (dashed lines) is illustrates relative widths of line portions 104C and 104A, 104B. As shown, line portion 104A or 104B is laterally wider than line portion 104C (along the y-direction). In one embodiment, line portion 104A and 104B have a width W_{A}, and the line portion 104C has a width Wc, where W₄ is greater than Wc. In embodiments, W_{A} is greater than W_{C} by at least 5nm.

**Figure 2D** is a cross sectional illustration through the line C-C' of the structure in Figure 2A. In the illustrative embodiment, the line portion 104C has a rectangular cross section in the y-z plane and channel 108 is on at least 3 surfaces of the line portion 104C. As shown channel 108 is adjacent to surface 104G, and sidewalls 104H and 104J of line portion 104C. Such a channel 108 may be referred to as a saddle channel 108. As shown, the gate dielectric layer 202A and the gate electrode 202B are conformal with sidewalls 104H and 104J and surface 104G. In some such embodiments, the deck select transistor 200 is known as a saddle-FET.

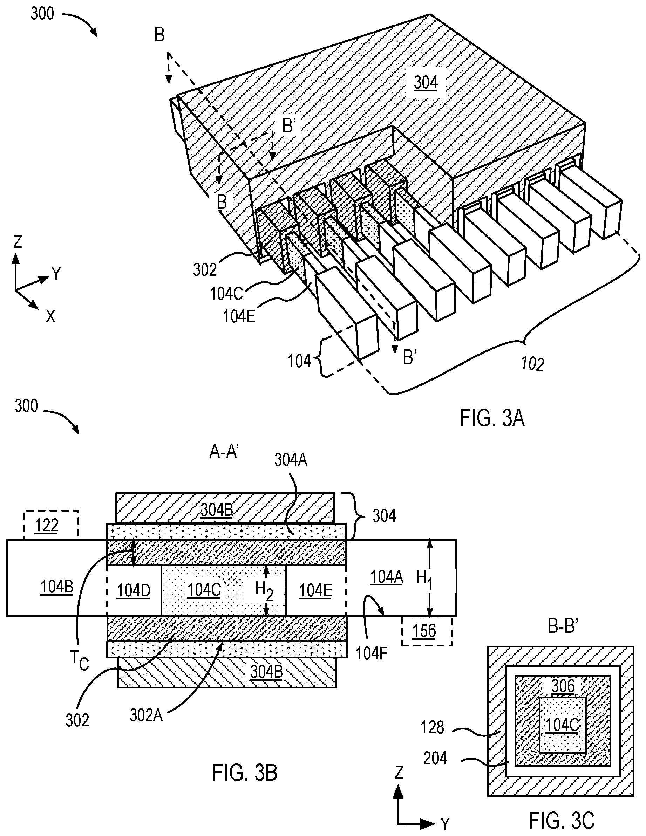

**Figure 3A** is an isometric illustration of a deck select transistor 300 in accordance with embodiments of the present invention. As shown, each line in line structure 102 has varying material compositions along a longitudinal length (x-axis). In the illustrative embodiment, each line of line structure 102 also has a cross-sectional area in the y-z plane that varies along the x-axis in regions within and away from transistor channel 302. A portion of transistor channel 302 and gate structure 304 is cut out to reveal a shape of a representative line structure, such as line 104 and transistor channel 302. A gate dielectric layer is not shown in the Figure to provide clarity. In the illustrative embodiment, transistor channel 302 surrounds line portions 104C, 104D (not visible) and 104E. In the illustrative embodiment, channel 302 asymmetrically surrounds the line 104. In embodiments, gate structure 304 has one or more features of the gate structure 202. As shown, gate structure 302 couples each transistor channel in each line of line structure 102.

**Figure 3B** is a cross sectional illustration of a deck select transistor 300 through the line A-A' in the structure of **Figure 3A**. In the illustrative embodiment, line 104 has one or more of the features described above in association with **Figure 2B****.**

In the illustrative embodiment, transistor channel 302 extends laterally beyond line portion 104C along the x-axis, and over line portions 104D and 104E. Transistor channel 302 has a thickness, T_{C}. In the illustrative embodiment, the transistor channel 302 has a thickness, T_{C} that is substantially equal to a difference between respective heights of the line portions 104A and line portion 104C, 104D or 104E. In other embodiments T_{C} is greater or less than a difference between respective heights of the line portions 104A and line portion 104C, 104D or 104E. However, as shown, the channel 302 has a lowermost surface 302A that is below the lowermost surface 104F of the line portion 104A. As shown, the gate dielectric layer 304A and gate electrode 304B of gate structure 304 are also below the lowermost surface 104F.

In embodiments, gate dielectric layer 304A and gate electrode 304B include a material that is the same or substantially the same as the material of the gate dielectric layer 204A and gate electrode 204B, respectively, as described in association with Figure 2B. In an embodiment, the transistor channel 302 includes a material that is the same or substantially the same as the material of the channel 108.

In some embodiments gate structure 304 includes one or more work function layers (gate electrode 304B), and a fill metal on the one or more work function layers, where the fill metal (not shown in illustration) fills a space between gate electrodes of respective adjacent lines. In some such embodiments, gate structure 304 includes a layer of additional conductive material extending above gate electrode 304B. The layer of additional conductive material may also extend below portion of the gate electrode 304B that is under surface 104F.

**Figure 3C** is a cross sectional illustration through the line B-B' of the structure in **Figure 3A****.** In the illustrative embodiment, the line portion 104C has a rectangular cross section in the y-z plane and transistor channel 302 clads line portion 104C. As shown, the gate dielectric layer 304A clads line portion 104C and the channel 302, and gate electrode 304B clads gate dielectric layer 304A. In some such embodiments, the deck select transistor 300 is known as a gate all round-FET. Depending on the application, deck select transistor 300 may be a P-FET or an N-FET.

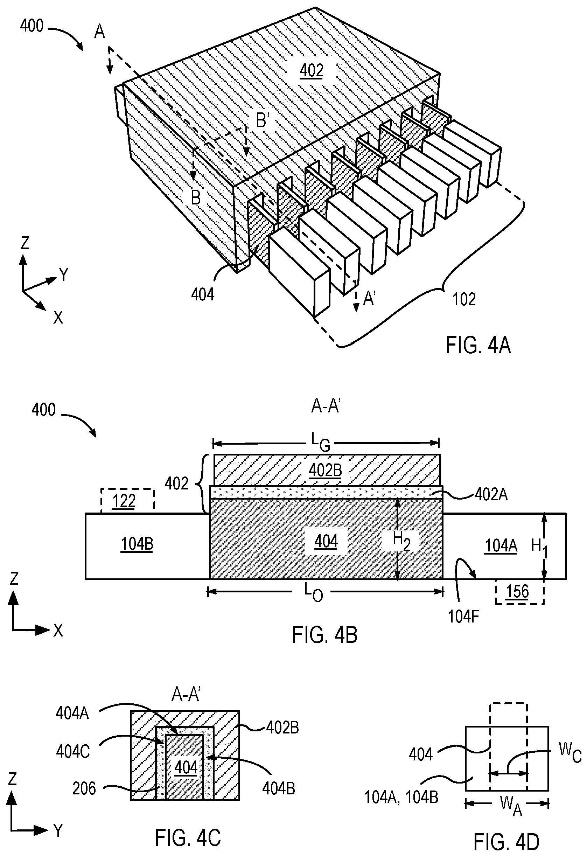

In a third embodiment, a deck select transistor includes a fin-FET architecture (an example of a non-planar transistor). **Figure 4A** is an isometric illustration of deck select transistor 400, in accordance with embodiments of the present invention. A portion of gate structure 402 is cut out to reveal a shape of a representative transistor channel, such as transistor channel 404. A gate dielectric layer is not shown in the Figure to provide clarity. Gate structure 402 is adjacent to each line of line structure 102.

**Figure 4B** is a cross sectional illustration of deck select transistor 400 through the line A-A' in the structure of **Figure 4A****.** In the illustrative embodiment, line 104 has first and second portions 104A and 104B. As shown, line 104 also includes deck select transistor channel 404 between the line portions 104A and 104B. In the illustrative embodiment, line portion 104A is one of a source or a drain region and line portion 104B is the other of the source or a drain region of deck select transistor 400. Transistor channel 404 has a length, L_{O}, as shown. In embodiments L_{O} is between 50 nm and 600 nm

Line portions 104A and 104B have a height, H₁, as shown. In embodiments, H₁ is between 15 nm and 100 nm. Transistor channel 404 has a height, H₂. As shown, H₂ is greater than H₁. In embodiments, H₂ is between 10 nm and 95 nm. In exemplary embodiments, H₂ is substantially uniform along the x-axis. Depending on a desired fin height, H₂ may be less than H₁.

As shown, gate structure 402 is on the channel 404 in the cross-sectional illustration. Depending on a fabrication process the gate structure 402 has a gate length, L_{G}, that is less than or equal to a length, L_{O}, of the transistor channel 404. When L_{G}, is less than L_{O}, gate dielectric layer 402A may be adjacent to sidewalls of the gate electrode 402B. It is to be appreciated that memory cell 122 is coupled with line portion 104B of deck select transistor 400 and terminal interconnect 155 is coupled with line portion 104A of deck select transistor 400.

In embodiments, gate dielectric layer 402A and gate electrode 402B include a material that is the same or substantially the same as the material of the gate dielectric layer 204A and gate electrode 204B, respectively. In an embodiment, the transistor channel 404 includes a material that is the same or substantially the same as the material of the channel 108.

In some embodiments gate structure 402 includes one or more work function layers (gate electrode 402B), and a fill metal on the one or more work function layers, where the fill metal (not shown in illustration) fills a space between gate electrodes of respective adjacent lines. In some such embodiments, gate structure 402 includes a layer of additional conductive material extending above gate electrode 402B.

**Figure 4C** is a cross sectional illustration through the line B-B' of the structure in **Figure 4A****.** In the illustrative embodiment, transistor channel 404 has a rectangular cross section on the y-z plane. As shown, transistor channel 404 has a rectangular cross section in a y-z plane. In the illustrative embodiment, gate dielectric layer 402A is on top surface 404A, and on sidewall surfaces 404B and 404C of transistor channel 404. The gate electrode 402B is on the gate dielectric layer 402A adjacent to surfaces 404A, 404B and 404C. In some such embodiments, the deck select transistor 300 is known as a fin-FET (an example of a non-planar transistor). Depending on the application deck select transistor 400 may be a P-FET or an N-FET.

**Figure 4D** is a cross sectional illustration through the line B-B' of the structure in Figure 4A. In the illustrative embodiment, an outline of transistor channel 404 (dashed lines) illustrates relative widths of the line 104 and the channel 404. As shown, line portion 104A and 104B are laterally wider (along the y-direction) than transistor channel 404. As shown, line portion 104A and 104B have a width W_{A}, and the line portion 104C has a width Wc. In the illustrative embodiment, W_{A} is greater than Wc. In embodiments, W_{A} is greater than W_{C} by at least 5 nm.

Referring again to Figure 1, the memory device structure 100 further includes a group of terminal interconnects, that couple lines which are aligned along a same direction across two or more decks. In the illustrative embodiment, each terminal interconnect group 154 and 158, includes a plurality of terminal interconnects. In the illustrative embodiment, each terminal interconnect in terminal interconnect group 154 is coupled between a single line in line structure 102 and a corresponding vertically aligned line in line structure 132. For example, lines 104 and 134 are coupled by a terminal interconnect 155, lines 106 and 136 are coupled by a terminal interconnect 156. During operation, any single terminal interconnect, such as terminal interconnect 155 can simultaneously bias two lines 104 and 134 on two different decks to a same potential. However, a single memory cell such as memory cell 122 may be preferably programmed over memory cell 152 (below memory cell 122) by applying a bias on deck select transistor 101A.

In the illustrative embodiment, each transistor channel, is between a terminal interconnect and a memory cell. For example, channel 108 is laterally between memory cell 122 and terminal interconnect 155, and transistor channel 138 is laterally between memory cell 152 and terminal interconnect 155. Similarly, transistor channel 110 is laterally between memory cell 124 and terminal interconnect 155 and transistor channel 140 is laterally between memory cell 153 and terminal interconnect 156.

Also as shown, each terminal interconnect in terminal interconnect group 158 is coupled between a single line in line structure 112 of deck 128 and a corresponding vertically aligned line within line structure 142 of deck 130. In the illustrative embodiment, lines 114 and 144 are coupled by a terminal interconnect 160, and lines 116 and 146 are coupled by a terminal interconnect 162. During operation, terminal interconnect 160 can simultaneously bias two line 114 and 144 on two different decks to a same potential.

In the illustrative embodiment, transistor channel 118 is laterally between memory cell 122 and terminal interconnect 160, and transistor channel 120 is laterally between memory cell 152 and terminal interconnect 155. Similarly, transistor channel 148 is laterally between memory cell 152 and terminal interconnect 160 and transistor channel 150 is laterally between memory cell 164 and terminal interconnect 162.

In an embodiment the lines in each of the line structures 102, 112, 132 and 142 include a metal such as tungsten, tantalum or titanium or an alloy that includes nitrogen and at least one of tungsten tantalum or titanium.

In an embodiment transistor channels 110, 118, 120, 138, 140, 148 and 150 each include a polycrystalline or an amorphous material that is suitable for a thin film transistor.

In some embodiments, channels 110, 118, 120, 138, 140, 148 and 150 etc. include an n-type semiconductor material. Examples of n-type semiconductor material include two or more of In,Ga, Zn, Mg, Al, Sn, Hf, O, W such as In₂O₃, Ga₂O₃, ZnO, InGaZnO, InZnO, InGaO, GaZnO, InAlO, InSnO, InMgO, InWO, GaZnMgO, GaZnSnO, GaAlZnO, GaAlSnO, HfZnO, HfInZnO, HfAlGaZnO or InMgZnO.

In embodiments an n-type channel may be doped with Ti, W, Cu, Mn, Mg, Fe, Hf, Al, Ni, CO or Ru. In embodiments, the dopant concentration is between 10¹⁶ and 10²⁰atoms/cm³, and wherein the channel comprises a thickness between 1 nm to 80 nm.

In other embodiments, channels 110, 118, 120, 138, 140, 148 and 150, etc. include a p-type material. Examples of p-type semiconductor material include NbO, NiO, CoO, SnO, Cu₂O, AgAlO, CuAlO₃, AlScOC, Sr₃BPO₃, La₂SiO₄Se, LaCuSe, Rb₂Sn₂O₃, La₂O₂S₂, K₂Sn₂O₃, Na₂FeOSe₂, ZnRh₂O₄ or CuOₓ, where x is 1 or 2.

In an embodiment, each of the interconnects 155, 156, 160, 162 include copper, tungsten, tantalum, titanium, hafnium, zirconium, aluminum, silver, tin, lead, ruthenium, molybdenum, cobalt, and their alloys, or alloy including nitrogen and one or more of copper, tungsten, tantalum, titanium, hafnium, zirconium, aluminum, silver, titanium, tin or lead. In some embodiments, each of the interconnects 155, 156, 160, 162 include metal carbides such as hafnium carbide, zirconium carbide, titanium carbide, tantalum carbide or aluminum carbide.

In the illustrative embodiment, memory device structure 100 further includes additional memory cells corresponding to an additional deck between deck 128 and deck 130.

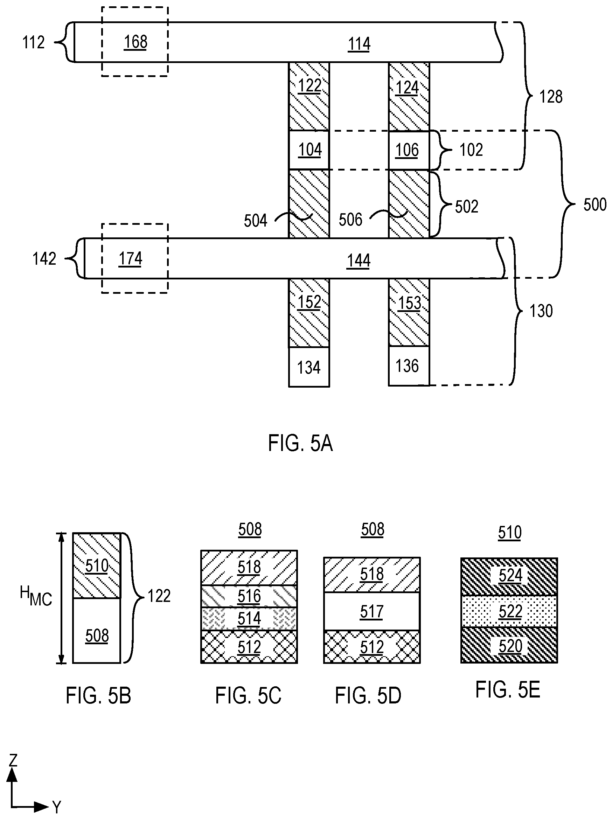

**Figure 5A** is a cross sectional illustration through a line A-A' of the structure in **Figure 1** and illustrates arrangement of additional memory cells within a deck 500. Deck 500 includes line structures 102 and 142, and memory cell array 502. In the cross-sectional illustration two memory cells are shown such as a memory cell 504 between line 104 and line 144, and a memory cell 506 between line 106 and line 144. Other memory cells at the intersection between the respective lines in each of the line structure 102 and 142 are not visible in the cross-sectional illustration.

In embodiments, associated transistors corresponding to each deck can all be P-FET or N-FET. In some embodiments, where both a P-FET or an N-FET is implemented in memory device structure 100, the N-FET and P-FET transistors are on alternate line structures. For example, deck select transistors corresponding to channels 104 and 106 may be P-FET or N FET, deck select transistors corresponding to channels 118 and 120 may be N-FET or P-FET, deck select transistors corresponding to channels 148 and 150 may be P-FET or N-FET, and deck select transistors corresponding to channels 138 and 140 may be N-FET or P-FET.

It is to be appreciated that in some embodiments all memory cells within a given deck have a same configuration, i.e, either the non-volatile memory element is on the selector device, or vice versa.

In an embodiment, a memory cell 122 has a structure as shown in **Figure 5B****,** where a selector element 508 is above a non-volatile memory element 510. In other embodiments selector element 508 is below non-volatile memory element 510. The non-volatile memory element 510 may include phase change memory, a resistive random access memory (R-RAM), ovonic threshold switching (OTS) memory or a conductive bridge RAM.

Also as shown, each of the memory cells 122, 124, 504 and 106, 152 and 153 have a height, H_{MC}. In embodiments, H_{MC} depends on thicknesses and structures of each of the respective selector element 508 and non-volatile memory element 510.

**Figure 5C** illustrates a cross-sectional view of an example non-volatile memory element 502 that includes a resistive random-access memory (RRAM) device that includes oxygen vacancy switching. In the illustrated embodiment, the RRAM material stack includes a bottom electrode 512, a switching layer 514 over the bottom electrode 512, an oxygen exchange layer 516 over the switching layer 514, and a top electrode 518 on the oxygen exchange layer 516.

In an embodiment, bottom electrode 512 includes an amorphous layer. In an embodiment, bottom electrode 512 is a topographically smooth electrode. In an embodiment, bottom electrode 512 includes a material such as W, Ta, TaN or TiN. In an embodiment, bottom electrode 512 is composed of Ru layers interleaved with Ta layers. In an embodiment, bottom electrode 512 has a thickness is between 20 nm and 50 nm. In an embodiment, top electrode 518 includes a material such as W, Ta, TaN or TiN. In an embodiment, top electrode 518 has a thickness is between 120 and 70 nm. In an embodiment, bottom electrode 512 and top electrode 518 are the same metal such as Ta or TiN.

Switching layer 514 may be a metal oxide, for example, including oxygen and atoms of one or more metals, such as, but not limited to Hf, Zr, Ti, Ta or W. In the case of titanium or hafnium, or tantalum with an oxidation state +4, switching layer 514 has a chemical composition, MO_{X}, where O is oxygen and X is or is substantially close to 2. In the case of tantalum with an oxidation state +5, switching layer 514 has a chemical composition, M₂O_{X}, where O is oxygen and X is or is substantially close to 5. In an embodiment, switching layer 514 has a thickness is between 1 nm and 5 nm.

Oxygen exchange layer 516 acts as a source of oxygen vacancy or as a sink for O²⁻. In an embodiment, oxygen exchange layer 516 is composed of a metal such as but not limited to, hafnium, tantalum or titanium. In an embodiment, oxygen exchange layer 516 has a thickness is between 5 nm and 20 nm. In an embodiment, the thickness of oxygen exchange layer 516 is at least twice the thickness of switching layer 514. In another embodiment, the thickness of oxygen exchange layer 516 is at least twice the thickness of switching layer 514. In an embodiment, the RRAM device has a combined total thickness of the individual layers is between 60 nm and 100 nm and width is between 10 nm and 50 nm.

While an oxygen vacancy switching device is illustrated in Figure 5C, RRAM devices may include other examples such as phase change devices.

**Figure 5D** is a cross-sectional illustration of a structure of a memory element where an RRAM device includes a phase change layer. In the illustrative embodiment, non-volatile memory element 510 includes electrode layers 512 and 518 an insulator layer 517 between the electrode layers 512 and 518.

In some such embodiments, the insulator layer 517 exhibits charge carrier tunneling behavior. In some such embodiments, the insulator layer 517 includes oxygen and a metal, such as, but not limited, to aluminum, hafnium, tantalum and titanium. In further embodiments, the insulator layer 517 is also doped with atoms of one or more metals, such as, but not limit to, copper, silver or gold. In some such embodiments, the insulator layer 517 is doped to a concentration between 2%-10% (atomic) with atoms of one or more metals such as copper, silver or gold. In an embodiment, the insulator layer 517 has a thickness between 2 nm to 5 nm.

In another embodiment, the insulator layer 517 includes a threshold switching material such as a phase change material. In some examples, the insulator layer 517 may include a phase change material that exhibits at least two different electrical states characterized by two different resistances, a conductive state and a resistive state. In some examples, the phase change material exhibits at least two different material states, amorphous and crystalline that correspond to the two different resistance states. In an embodiment, a phase change material that is in a completely crystalline phase is conductive and resistive when the phase change material is in an amorphous state. However, by modulating the relative extent of crystalline phase and amorphous phase in a given volume of the phase change material the resistance of the phase change material can be tuned. In an embodiment, the resistance state of the phase change material may be set by heating and cooling the phase change material in a specific manner by application of a voltage bias, e.g., between electrodes 512 and 518 to induce joule heating.

In an embodiment, the phase change material includes Ge and Te. In an embodiment, the phase change material further includes Sb. In an embodiment, the phase change material includes a ternary alloy of Ge, Te and Sb such as Ge₂Sb₂Te₅. In an embodiment, the phase change material includes a binary alloy, ternary alloy or a quaternary alloy including at least one element from the group V periodic table such as Te, Se, or S. In an embodiment, the phase change material includes a binary alloy, ternary alloy or a quaternary alloy which comprises at least one of Te, Se, or S, where the said alloy further comprises one element from the group V periodic table such as Sb. In an embodiment, the phase change material includes a dopant such as silver, indium, gallium, nitrogen, silicon or germanium. In an embodiment, the dopant concentration is between 5% and 20% of the total composition of the phase change material. In an embodiment, the insulator layer 517 has a thickness (measured along e.g., x-axis) that is between 2 nm and 15 nm.

**Figure 5E** is a cross-sectional illustration of a structure of a selector element 508 of a memory cell in accordance with embodiments of the present invention. As shown, the selector device includes a metal-insulator-metal (MIM) stack. The MIM stack of selector element 510 includes a selector electrode 520, an insulator layer 522 between the selector electrode 520 and a selector electrode 524.

In embodiments, the insulator layer 522 includes a ovonic threshold switching material. In an embodiment, the insulator includes alloy of Ge, As and Se, such as GeAsSe, GeSe or AsSe. In embodiments the alloy Ge, As and Se may include dopants, for example As doped GeSe, Ge doped AsSe or GeAsSe doped with In, Te or Sb. In embodiments, the insulator layer 522 has a thickness that is material dependent, where the thickness is between 5 nm and 20 nm. Electrodes 520 and 524.may include a material that is the same or substantially the same as a material of electrodes 512 and 518.

In another embodiment, the insulator layer 522 includes a material that can undergo a reversible insulator to metal transition. In embodiments, the transition is triggered by a thermal process or by an electrical process. In some such embodiments, the insulator layer 522 includes oxygen and atoms of one or more metals, such as, but not limited to niobium, vanadium and tantalum. In some specific examples, the insulator layer 522 includes vanadium (IV) oxide, VO₂ and vanadium (V) oxide, V₂O₅ and niobium (V) oxide, Nb₂O₅. In one specific example, the insulator layer 522 includes niobium (V) oxide, Nb₂O₅ and may exhibit filamentary conduction. In an embodiment, the insulator layer 522 is amorphous. In an embodiment, the insulator layer 522 which can undergo an insulator to metal transition has a thickness between 5 nm and 20 nm.

In some embodiments where insulator-to-metal transition is to occur, the insulator layer 522 further includes a dopant such as silver, copper or gold. In an embodiment, the dopant concentration is between 0.1-10% of the total composition of the insulator layer 522. A dopant concentration between 0.1-10% may facilitate filament conduction.

In an embodiment, selector electrode 520 and 524 include a conductive material such as TiN and TaN or a metal such as Ta, W or Pt. In an embodiment, the selector electrodes 520 and 524 have a thickness between 5 nm and 20 nm. Electrodes 520 and 524 may or may not have a same thickness.

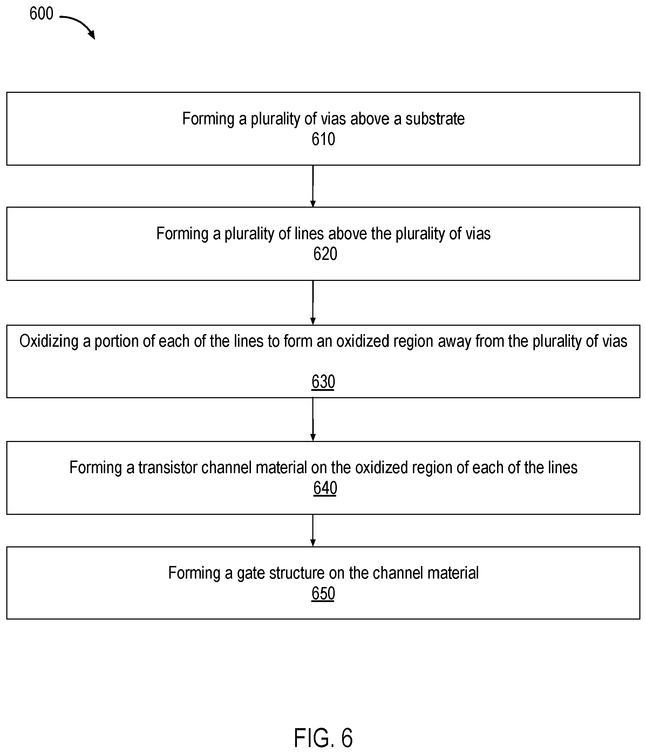

**Figure 6** is a method 600 to fabricate a deck select transistor 200 or 300 of **Figures 2A-2D** and **3A-3D**. The method 600 begins at operation 610 with the formation of a plurality of vias in a dielectric above a substrate. The method 600 continues at operation 620 with the formation of a plurality of lines above the individual ones of the vias. The method 600 continues at operation 630 with a process to oxidize a portion of the individual ones of the lines in the plurality of line to form an oxidized region within the individual ones of the lines, away from the vias. The method 600 continues at operation 640 with the formation of a transistor channel material on the oxidized region of each of the lines. The method 600 concludes at operation 650 with the formation of a gate structure on the channel material of each of the individual ones of the plurality of lines.

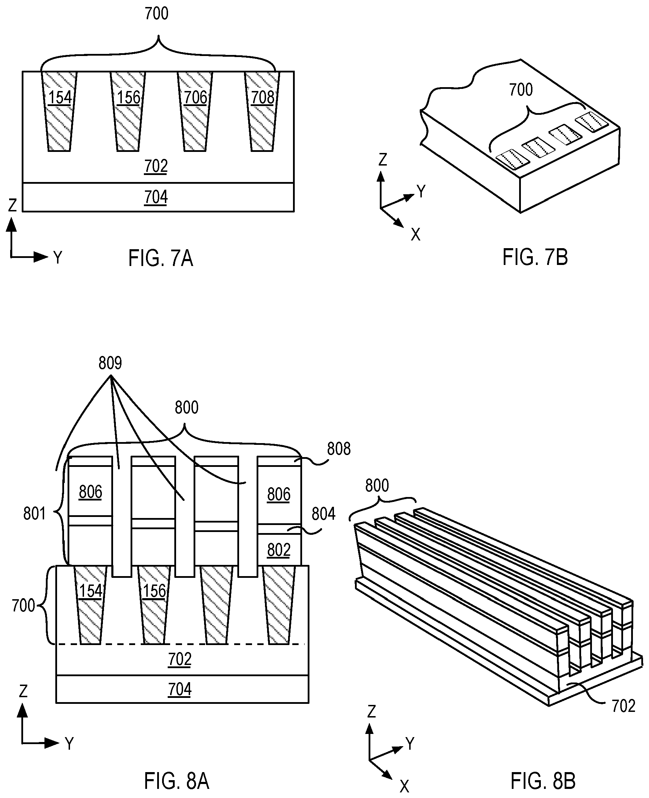

**Figure 7A** is a cross-sectional illustration a terminal interconnect array 700 formed in a dielectric 702 over a substrate 704.

In an embodiment, a plurality of vias are patterned into the dielectric 702 by a masking and an etching process. After formation of the plurality of vias, a liner layer followed by a fill metal is deposited into the plurality of vias and a planarization process is performed to form terminal interconnects 155, 156, 706 and 708. In an embodiment, the dielectric 702 includes silicon and one or more of oxygen, nitrogen or carbon and the patterning process includes a plasma etch. In an embodiment, the terminal interconnects 706 and 708 includes a same material as the material of the terminal interconnects 155 and 156.

**Figure 7B** is an isometric illustration of the terminal interconnect array 700 formed in a dielectric 702 over a substrate 704. In an embodiment, each terminal interconnect in the terminal interconnect array 700 has a substantially rectangular plan-view profile. In other embodiments, the plan view profile may be circular or elliptical.

**Figure 8A** illustrates the structure of **Figure 7A** following the formation of a plurality of line segments 800 above the substrate 704. In an embodiment, each line segment 801 of the plurality of line segments 800 includes a conductive line 802, a hardmask 804, a dielectric 806 and a hardmask 808 on the dielectric 806.

In an embodiment, a material layer stack of the plurality of line segment 801 is deposited on the dielectric 702 and on the terminal interconnects 700. In an embodiment, forming the material layer stack includes depositing a layer of a first hardmask material on a conductive layer, depositing a dielectric layer on the layer of hardmask material and depositing a layer of second hardmask material on the dielectric layer. A resist mask may be formed on the layer of second hardmask material and the material layer stack is patterned. In an embodiment, the patterning process includes a plasma etch process. Individual layers in the material layer stack are patterned to form plurality of line segments 800. The layer of second hardmask material is patterned to form a hardmask 808, the dielectric layer is patterned to form dielectric 806, the layer of first hardmask material is patterned to form hardmask 804 and the conductive layer is patterned to form a conductive line 802. As shown, a portion of the dielectric 702 is also recessed during the patterning process. It is to be appreciated that the terminal interconnects 700 is not exposed during the patterning process. In the illustrative embodiment, four-line segments 801 are shown. Formation of the four-line segments 801 creates openings 809 between each line segment 801. The number of lines in the line segments 800 equals the number of word or bit lines in the memory array.

In an embodiment, the hardmask 804 and 808 include silicon and one or more of oxygen, nitrogen or carbon. In an embodiment, the dielectric 806 includes silicon and one or more of oxygen, nitrogen or carbon. In exemplary embodiments, the dielectric 806 includes silicon and one or more of oxygen or carbon. In an embodiment, the conductive line 802 includes a material of the line 104.

**Figure 8B** is an isometric illustration of the structure in **Figure 8A****.**

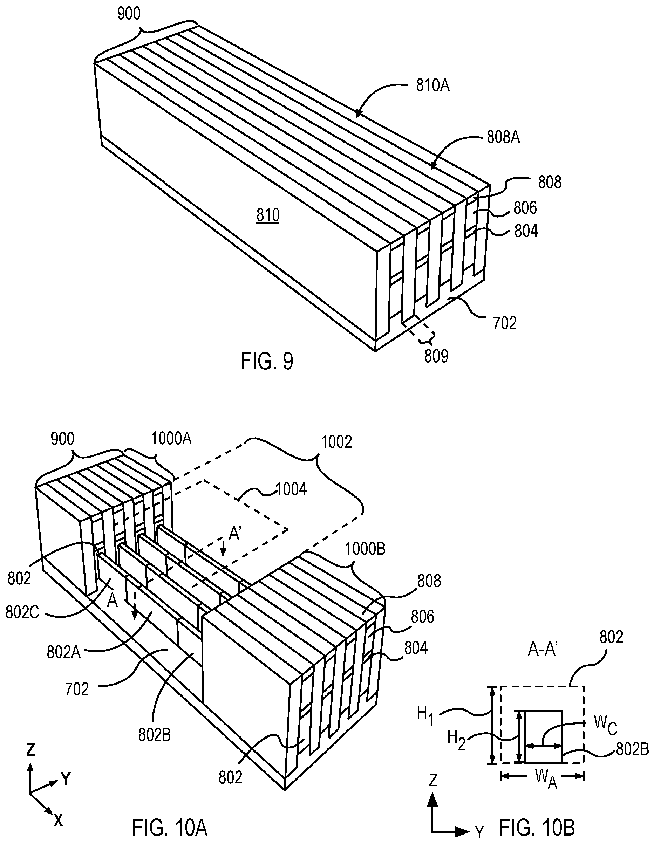

**Figure 9** illustrates the structure of **Figure 8B** following the formation of a dielectric 810 in each opening 809 to form a block 900. In an embodiment, a dielectric 810 is deposited in openings 809. The deposition process may include a PECVD (plasma enhanced chemical vapor deposition), physical vapor deposition (PVD), chemical vapor deposition (CVD) process. In an embodiment, the dielectric includes silicon and nitrogen and/or carbon. In an embodiment, the dielectric 810 is planarized. In an embodiment, a chemical mechanical polish (CMP) process is utilized to planarize the dielectric 810 which forms an uppermost surface 810A that is substantially co-planar, with an uppermost surface 808A of the hardmask 808.

**Figure 10A** illustrates the structure of **Figure 9** following the process of etching portions of the block 900. In an embodiment, a plasma etch process is utilized to etch dielectric 810, and portions of each line segment 801 to form a section 1000A and a section 1000B of the block 900. A region 1002 between the two sections 1000A and 1000B exposes line structures 802.

In an embodiment, the plasma etch process etches the hardmask 808, dielectric 806 and hardmask 804, and exposes an uppermost surface of dielectric 702 adjacent to the conductive line 802. A subsequent etch process is utilized to recess upper and side portions of the conductive line 802. In an embodiment, a combination of wet chemical and plasma etch processes are utilized to form lateral and vertical recesses.

After the etch process, the exposed region 1002 is partially masked and an oxidation process is performed. In an embodiment, a sacrificial mask includes a material that is not eroded by a plasma oxidation or a wet chemical process. An outline of the mask is defined by dashed lines 1004. The mask creates an opening over a portion of the region 1002. In an embodiment, a plasma oxidation or a wet chemical process is utilized to oxidize a portion of the conductive line 802 in the region 1002. The oxidation process forms an oxidized line portion 802A, between line portions 802B and 802C that are conductive. After the oxidation process, the sacrificial mask is removed. The length (along x-axis) of line portion 802A depends on a desired gate length of a transistor to be formed. In an embodiment, when the conductive line 802 includes a pure metal, such as W, Ta, Ti, or Ru or an alloy of the metal such as WN, TiN or TiN, line portion 802A is sufficiently oxidized to be non-conductive.

**Figure 10B** is a cross-sectional illustration taken along the line A-A' of the structure in **Figure 10A****.** A cross section of the line portion 802A is shown. A cross section of an unetched portion the conductive line 802 (denoted by dashed lines) is superimposed to show the relative sizes between the conductive line 802 and line portion 802A. As shown line portion 802A has a width that is laterally reduced from a width, W_{A}, to a lesser width, W_{C} after the etching process. The width W_{C} corresponds to a width of an unetched portion the conductive line 802. A height of the line portion 802A is reduced from H₁ to H₂. The reduction in height may be between 5 nm and 20 nm.

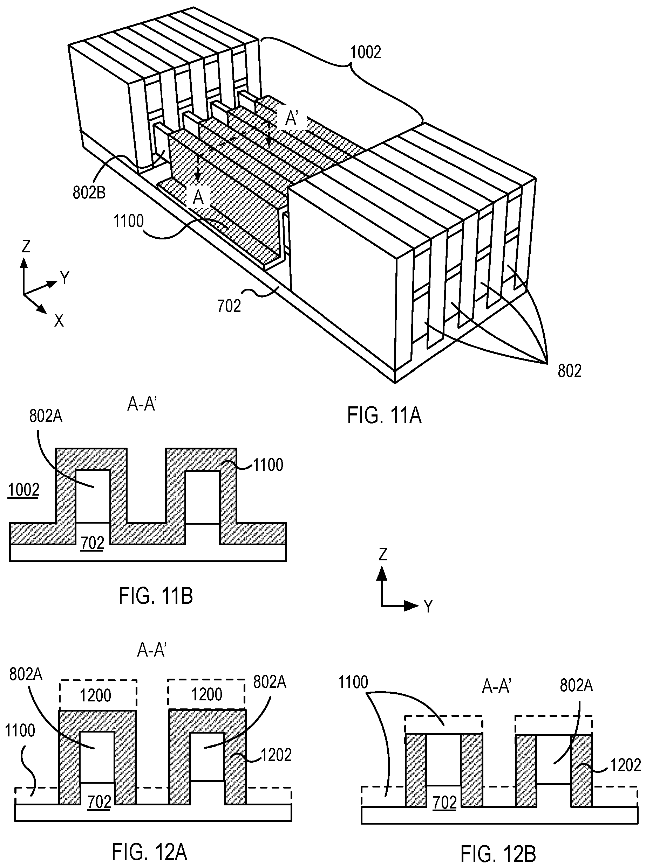

**Figure 11A** illustrates the structure of **Figure 10A** following the formation of a thin filmchannel material (herein channel material) 1100 over line portions 802A, 802B and 802C of each conductive line 802, in region 1002. In an embodiment, a mask (not shown in the Figure) is formed on the structure of **Figure 10A****.** A PVD, PEVCD, or a CVD deposition process may be utilized to deposit a channel material 1100. In an embodiment, channel material 1100 includes a material that is the same or substantially the same as the material of the channel 108. In an embodiment, the channel material 1100 is deposited on all surfaces of the line portions 802A, 802B and 802C exposed by the mask. The channel material 1100 is also deposited on exposed surfaces of dielectric 702. In an embodiment, the channel material 1100 is deposited to a thickness between 5 nm and 20 nm.

**Figure 11B** is a cross-sectional illustration taken along the line A-A' (slice through line portion 802A) of the structure in **Figure 11A****.** In the illustrative embodiment, the channel material 1100 is conformally deposited on sidewall and upper surfaces of the line portion 802A.

**Figure 12A** is a cross-sectional illustration of the structure in **Figure 11B** following the process to remove portions of the channel material 1100 above dielectric 702 and adjacent to line portion 802A. In an embodiment, a mask 1200 (inside dashed line 1200) is patterned over portions of the channel material 1100 above the line portion 802A. In an embodiment, a plasma etch process is utilized to etch and remove exposed portions the channel material 1100 uncovered by the mask 1200. The plasma etch process forms channel 1202 adjacent to each line portion 802A (and on portions 802B and 802C in in and out of the plane of the Figure). It is to be appreciated that the process to isolate each channel associated with each conductive line 802, enables each conductive line 802 to selectively program a memory cell in a memory device structure.

In some embodiments, channel material 1100 is also removed from a top surface of each line portion 802A, as is shown in **Figure 12B****.** The process utilized to mask and etch described above in association with **Figure 12A** may be utilized to form openings above the top surface of each line portion 802A. As shown, the plasma etch process forms channel 1202 adjacent to sidewalls of the line portion 802A.

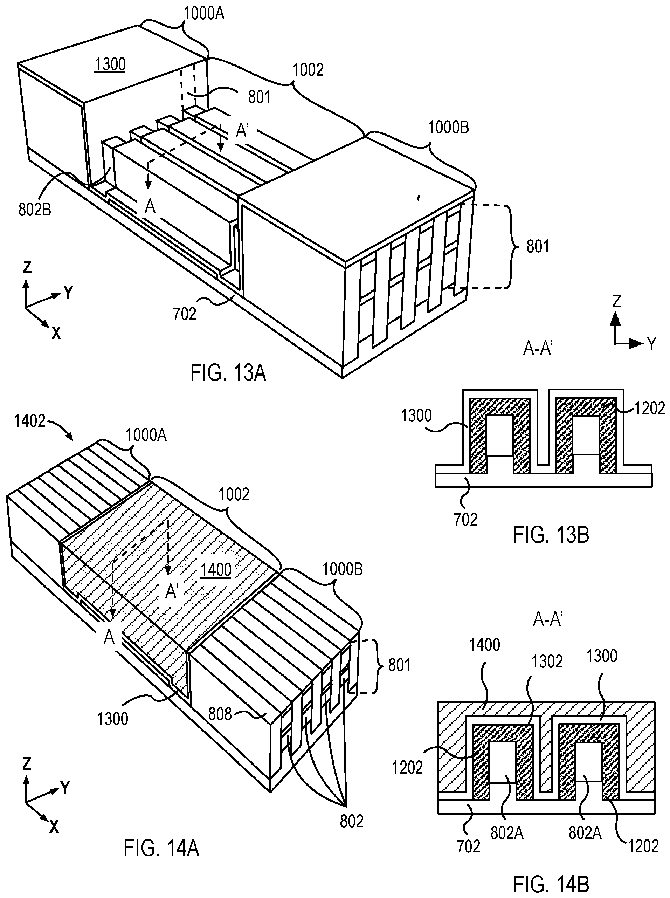

**Figure 13A** illustrates the structure of **Figure 11B** following the formation of a gate dielectric layer 1300. In an embodiment, gate dielectric layer 1300 includes a material that is the same or substantially the same as the material of the gate dielectric layer 202A. In an embodiment, the gate dielectric layer 1300 is blanket deposited on the structure of Figure 11B by an atomic layer deposition (ALD) or a PVD process. In an embodiment, the gate dielectric layer is deposited conformally on the channel 1202 (hidden in the illustration), on the dielectric 702, on line portions 802B and 802C (hidden in the illustration), and on sidewalls of each line segment 801 exposed in section 1002, The gate dielectric layer 1300 is also deposited on section 1000A and section 1000B, as shown.

**Figure 13B** is a cross-sectional illustration taken along the line A-A' of the structure in **Figure 13A****.** As shown gate dielectric layer 1300 is deposited conformally around channel 1202.

**Figure 14A** illustrates the structure of **Figure 13A** following the formation of a gate electrode 1400. In an embodiment, a material of gate electrode 1400 is blanket deposited on the gate dielectric layer 1300.

In an embodiment, the material of gate electrode 1400 is planarized. The planarization process may include, for example, a chemical mechanical polish (CMP) process. In the illustrative embodiment, the CMP process removes the material of gate electrode 1400 and gate dielectric layer 1300 in the regions 1000A and 1000B and forms gate electrode 1400 in region 1002. In an embodiment, the process to form the gate electrode 1400 completes a process to form a thin film transistor 1402 that has one or more of the properties discussed in association with **Figures 2A-2D****.** The planarization process is sufficiently selective to hardmask 808. As shown, the CMP process does not remove hardmask 808 from above each line segment 801. The hardmask 808 is also utilized as a polish stop during the fabrication process.

**Figure 14B** is a cross-sectional illustration taken along the line A-A' of the structure in **Figure 14A****.** In the illustrative embodiment, the gate electrode 1400 extends continuously across each channel 1202 that clads each line portion 802A. It is to be appreciated that during operation the gate electrode 1400 can activate each channel 1202 above each line portion 802A, if desired.

Referring again to **Figure 14A****,** in an embodiment, in a subsequent operation a material to fabricate memory cells above each line structure can be deposited after removing hardmask 808, dielectric 806 and hardmask 804 from above each conductive line 802. In some embodiments, a dielectric may be blanket deposited on the structure of Figure 14A and via openings may be formed to fabricate RRAM devices.

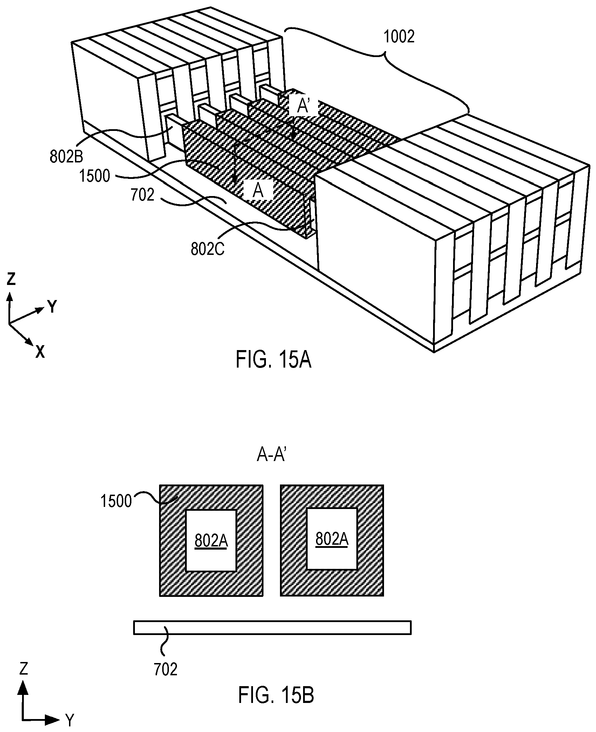

In other examples, transistor 306 may be fabricated by modifications to the process flow described in association with **Figures 7A-14B****.** In one embodiment, **Figure 15A** illustrates the structure of **Figure 9****,** where an ALD deposition process is utilized to selectively deposit a thin film transistor channel material (channel material) 1500 around the line portion 802A (hidden in Figure) and parts of line structure portion 802B and 802C not covered by a mask. In some such embodiments, the deposition process utilizes precursors that can favorably nucleate on oxidized metallic materials.

**Figure 15B** is a cross-sectional illustration of the structure in **Figure 15A** taken along a line A-A'. As shown, the deposit TFT channel material 1500 is deposited to entirely clad the line portion 802A to form discrete channels 1500. The method to form a gate electrode is substantially the same as one or more process operations described in association with **Figures 10A-14B****.**

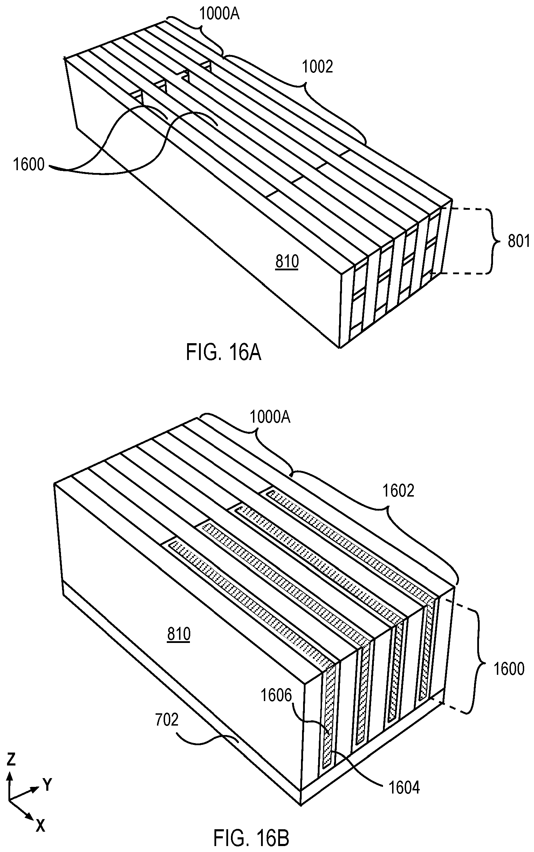

In other examples, a transistor, for example transistor 400 described in association with **Figure 4A** may be fabricated by modifications to the process flow described in association with **Figures 7A-14B****.** **Figure 16A** illustrates the structure of **Figure 9** following the formation of a plurality of openings 1600 in region 1002. In the illustrative embodiment, a plurality of openings 1600 are formed by completely etching out the line segment 801 completely.

**Figure 16B** illustrates the structure of **Figure 16A** following the formation of a sacrificial dielectric 1604 in each opening 1600, on the dielectric 702 followed by the formation of a channel layer 1606 on the dielectric 1604, in each of the plurality of openings 1600. A portion 1602 of the region 1002 is shown for clarity. In an embodiment, the dielectric is deposited by an ALD process. In an embodiment, the channel layer 1606 is deposited or grown on the channel layer 1606. In embodiments, the channel layer 1606 includes a material that is the same or substantially the same as the material of the channel layer 404. In an embodiment, the dielectric 1604 includes a material that is the same or substantially the same as the material of the dielectric 702. In an embodiment, a lateral thickness of opening 1600 (along the y-axis) and a deposition thickness of the dielectric 1604 can be controlled to obtain a desired lateral thickness (y-axis) of the channel layer 1606.

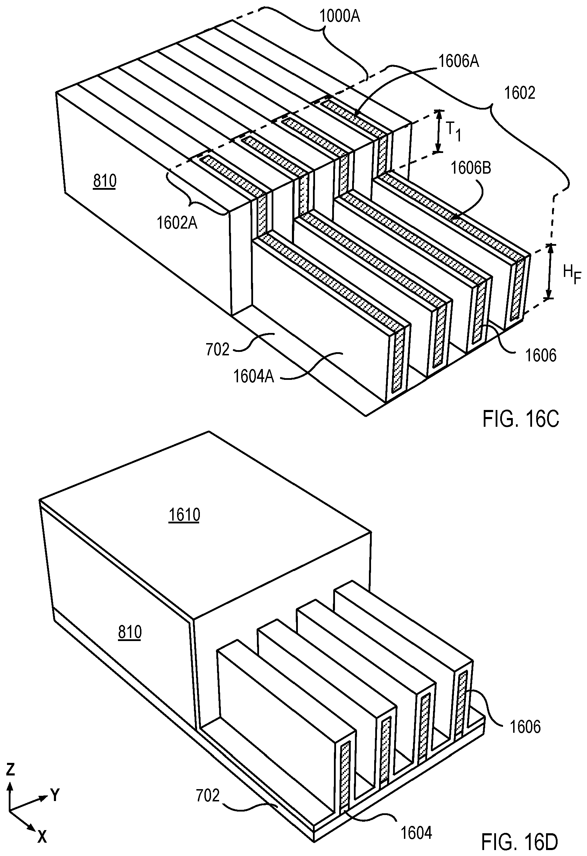

**Figure 16C** illustrates the structure of **Figure 16D** following a process to reduce a height of the channel layer 1606. In an embodiment, the dielectric 1604 and the channel layer 1606 are recessed by a plasma etch process, a wet chemical etch process or a combination thereof. As shown dielectric 1604 and channel layer 1606 are recessed by a thickness T₁, relative to an uppermost surface 1606A of the channel layer 1606. The channel layer 1606 may be recessed vertically prior to recessing the dielectric to prevent reduction in lateral thickness of channel layer 1606). The channel layer 1606 may be recessed to a desired height, H_{F}, of a fin structure to be formed. As shown, a top surface 1606B of the channel layer 1606 is substantially planar. In some embodiments, there is rounding of top edge portions of the channel layer 1606.

The process to selectively recess dielectric 1604 and channel layer 1606, may be performed after masking region 1000A and a portion 1602A of the region 1602. In the illustrative embodiment, an exposed portion of the dielectric 810 in the region 1602 is removed after recessing the dielectric 1604 and channel layer 1606.

In an embodiment, exposed sidewalls of dielectric 1604A are removed prior to formation of a gate structure at a next operation.

**Figure 16D** illustrates the structure of **Figure 16C** following the formation of a gate dielectric layer 1610 after removal of exposed sidewalls of dielectric 1604B (illustrated in **Figure 16C**). The gate dielectric layer 1610 includes a material that is the same or substantially the same as the material of the gate dielectric layer 202A. In the illustrative embodiment, the gate dielectric layer is deposited conformally around the channel layer 1606, on the dielectric 702 and adjacent to portions of dielectric 1604 that is under the channel 1606. Gate dielectric layer 1610 is also deposited on upper surfaces of hardmask 808 (hidden in Figure), and dielectric 810 on uppermost surface of channel layer 1606A and on the adjacent dielectric 1604. In an embodiment, the gate dielectric layer 1610 is deposited by an ALD process to a thickness between 1 nm and 10 nm.

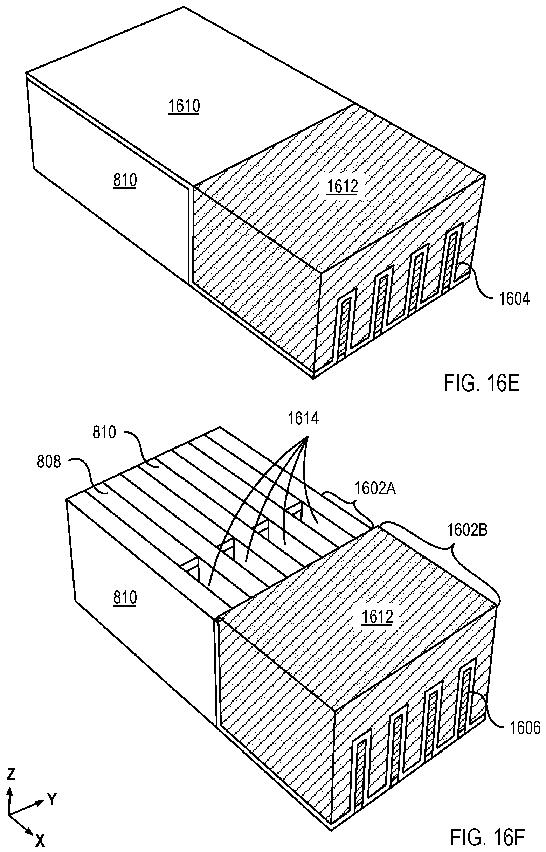

**Figure 16E** illustrates the structure of **Figure 16D** following the formation of a gate electrode 1612 on the gate dielectric layer 1610. In an embodiment, the process to form the gate electrode 1612 is the same or substantially the same as the process utilized to form gate electrode 1400. In an embodiment, a material of the gate electrode 1612 is blanket deposited on gate dielectric layer 1610 and a planarization is performed. In the illustrative embodiment, the planarization process isolates the gate electrode 1612 but does not remove the gate dielectric layer 1610.

**Figure 16F** illustrates the structure of **Figure 16E** following the process to remove portions of gate dielectric layer 1610. In an embodiment, the gate dielectric layer is removed from above the hardmask 808, dielectric 810, from above portions of the dielectric 1604 and channel layer 1606 in region 1602A. In the illustrative embodiment, dielectric 1604 and channel layer 1606 in region 1602A are etched and removed after removing gate dielectric layer 1610 in region 1602A. Openings 1614 are formed in region 1602 adjacent to region 1602B.

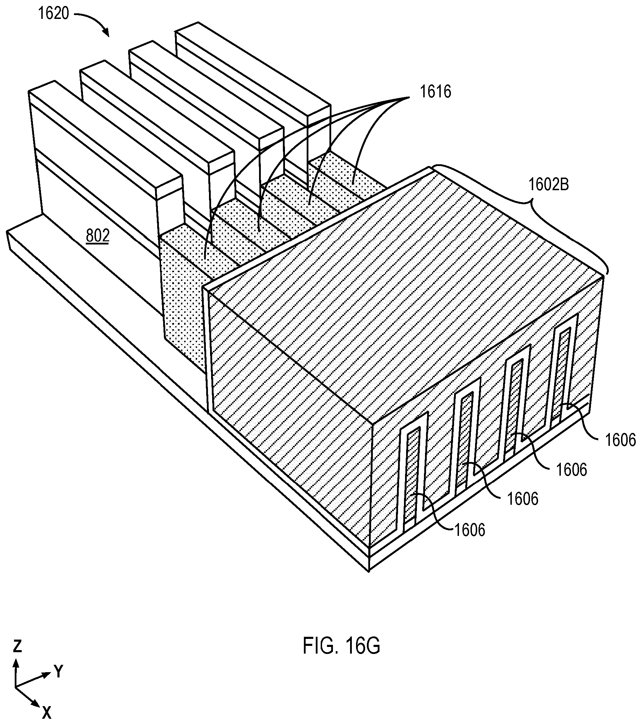

**Figure 16G** illustrates the structure of **Figure 16F** following the formation of source structure 1616 adjacent to each channel 1606 in region 1602B. In an embodiment, the source structure 1616 includes a material such as the material of the line 802 to prevent barrier junction from forming between line 802 and the source structure 1616. The source structure may have a height that is above or below the conductive line 802. The dielectric 810 is not shown in the illustration for clarity. While only the formation of the source structure 1616has been illustrated, a drain structure is formed on an opposite end of the source structure simultaneously during the fabrication process. Transistor 1620 is an example of a fin-FET transistor and has one or more features of the transistor 400 described in association with **Figure 4B****.**

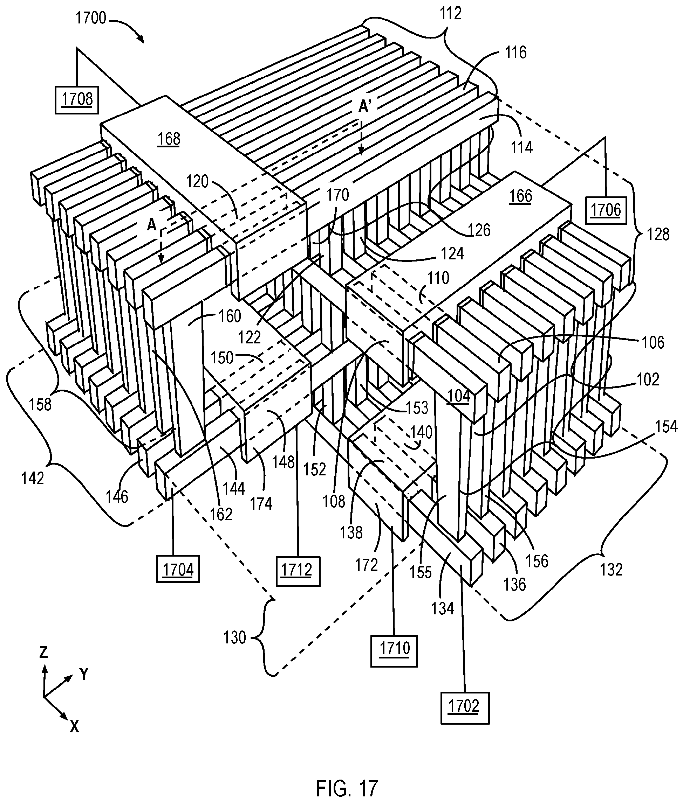

**Figure 17** is an isometric illustration of a system 1700 where a memory device structure such as memory device structure 100 including a plurality of deck select transistors, is coupled by a plurality of logic decoder transistors and programming transistors. In the illustrative embodiment, line 134 and line 144 are coupled by decoder transistor 1702 and 1704, respectively. While not shown, each line structure in the line structure 132 and 142 and deck 130 are coupled with a decoder transistor. In the illustrative embodiment, the line structures 102 and 112 are coupled to decoder transistors via the line structure 132 and 142, respectively. In some such embodiments, the total number of decoder transistors such as decoder transistor 1702 or 1704 is equal to the total number of line structures in each of the plurality of lines structures 132 and 142.

In the illustrative embodiment, each of the gate structures 166, 168, 172 and 174 are independently coupled with logic programming transistors 1706, 1708, 1710 and 1712, respectively. In some such embodiments, the total number of programming transistors is equal to the total number of independent gate structures in the memory device structure 100.

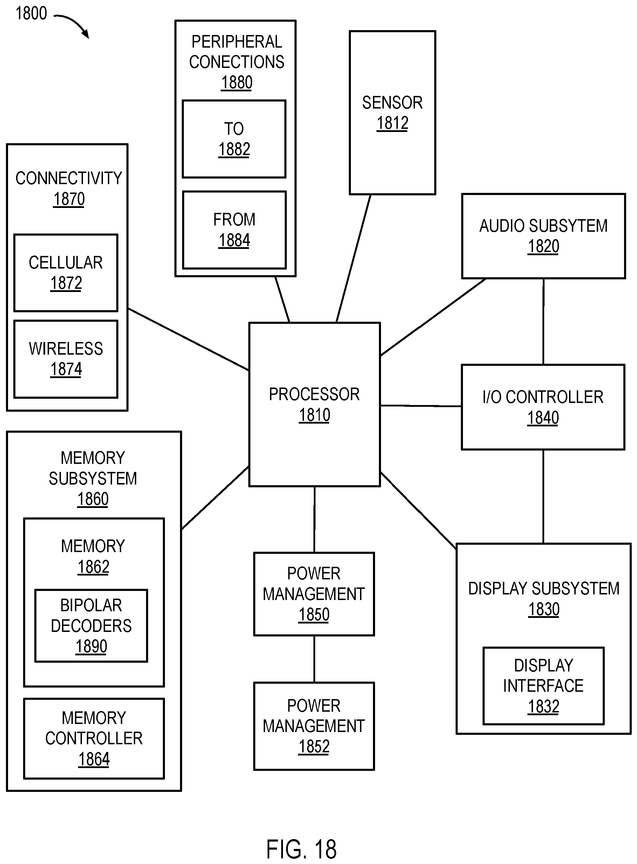

**Figure 18** is a block diagram of an example of a system 1800 that includes a deck select transistor within a memory device structure to enable decoder transistor footprint scaling. System 1800 represents a mobile computing device, such as a computing tablet, a mobile phone or smartphone, wearable computing device, or other mobile device, or an embedded computing device. It will be understood that certain of the components are shown generally, and not all components of such a device are shown in system 1800.

Memory 1862 includes a memory device structure, such as for example memory device structure 100 of Figure 1. In one example, deck select transistors 1890 represent deck select transistors in accordance with any example provided herein. The deck select transistors 1890 enable memory 1862 to provide selection of a target cell within the memory array. The use of the described deck select transistors enables selection with lower energy usage as compared to traditional decoder transistors.

System 1800 includes processor 1810, which performs the primary processing operations of system 1800. Processor 1810 can include one or more physical devices, such as microprocessors, application processors, microcontrollers, programmable logic devices, or other processing means. The processing operations performed by processor 1810 include the execution of an operating platform or operating system on which applications and device functions are executed. The processing operations include operations related to I/O (input/output) with a human user or with other devices, operations related to power management, operations related to connecting system 1800 to another device, or a combination. The processing operations can also include operations related to audio I/O, display I/O, or other interfacing, or a combination. Processor 1810 can execute data stored in memory. Processor 1810 can write or edit data stored in memory.

In one example, system 1800 includes one or more sensors 1812. Sensors 1812 represent embedded sensors or interfaces to external sensors, or a combination. Sensors 1812 enable system 1800 to monitor or detect one or more conditions of an environment or a device in which system 1800 is implemented. Sensors 1812 can include environmental sensors (such as temperature sensors, motion detectors, light detectors, cameras, chemical sensors (e.g., carbon monoxide, carbon dioxide, or other chemical sensors)), pressure sensors, accelerometers, gyroscopes, medical or physiology sensors (e.g., biosensors, heart rate monitors, or other sensors to detect physiological attributes), or other sensors, or a combination. Sensors 1812 can also include sensors for biometric systems such as fingerprint recognition systems, face detection or recognition systems, or other systems that detect or recognize user features. Sensors 1812 should be understood broadly, and not limiting on the many different types of sensors that could be implemented with system 1800. In one example, one or more sensors 1812 couples to processor 1810 via a frontend circuit integrated with processor 1810. In one example, one or more sensors 1812 couples to processor 1810 via another component of system 1800.

In one example, system 1800 includes audio subsystem 1820, which represents hardware (e.g., audio hardware and audio circuits) and software (e.g., drivers, codecs) components associated with providing audio functions to the computing device. Audio functions can include speaker or headphone output, as well as microphone input. Devices for such functions can be integrated into system 1800, or connected to system 1800. In one example, a user interacts with system 1800 by providing audio commands that are received and processed by processor 1810.

Display subsystem 1830 represents hardware (e.g., display devices) and software components (e.g., drivers) that provide a visual display for presentation to a user. In one example, the display includes tactile components or touchscreen elements for a user to interact with the computing device. Display subsystem 1830 includes display interface 1832, which includes the particular screen or hardware device used to provide a display to a user. In one example, display interface 1832 includes logic separate from processor 1810 (such as a graphics processor) to perform at least some processing related to the display. In one example, display subsystem 1830 includes a touchscreen device that provides both output and input to a user. In one example, display subsystem 1830 includes a high definition (HD) or ultra-high definition (UHD) display that provides an output to a user. In one example, display subsystem includes or drives a touchscreen display. In one example, display subsystem 1830 generates display information based on data stored in memory or based on operations executed by processor 1810 or both.

I/O controller 1840 represents hardware devices and software components related to interaction with a user. I/O controller 1840 can operate to manage hardware that is part of audio subsystem 1820, or display subsystem 1830, or both. Additionally, I/O controller 1840 illustrates a connection point for additional devices that connect to system 1800 through which a user might interact with the system. For example, devices that can be attached to system 1800 might include microphone devices, speaker or stereo systems, video systems or other display device, keyboard or keypad devices, or other I/O devices for use with specific applications such as card readers or other devices.

As mentioned above, I/O controller 1840 can interact with audio subsystem 1820 or display subsystem 1830 or both. For example, input through a microphone or other audio device can provide input or commands for one or more applications or functions of system 1800. Additionally, audio output can be provided instead of or in addition to display output. In another example, if display subsystem includes a touchscreen, the display device also acts as an input device, which can be at least partially managed by I/O controller 1840. There can also be additional buttons or switches on system 1800 to provide I/O functions managed by I/O controller 1840.

In one example, I/O controller 1840 manages devices such as accelerometers, cameras, light sensors or other environmental sensors, gyroscopes, global positioning system (GPS), or other hardware that can be included in system 1800, or sensors 1812. The input can be part of direct user interaction, as well as providing environmental input to the system to influence its operations (such as filtering for noise, adjusting displays for brightness detection, applying a flash for a camera, or other features).

In one example, system 1800 includes power management 1850 that manages battery power usage, charging of the battery, and features related to power saving operation. Power management 1850 manages power from power source 1852, which provides power to the components of system 1800. In one example, power source 1852 includes an AC to DC (alternating current to direct current) adapter to plug into a wall outlet. Such AC power can be renewable energy (e.g., solar power, motion based power). In one example, power source 1852 includes only DC power, which can be provided by a DC power source, such as an external AC to DC converter. In one example, power source 1852 includes wireless charging hardware to charge via proximity to a charging field. In one example, power source 1852 can include an internal battery or fuel cell source.

Memory subsystem 1860 includes memory device(s) 1862 for storing information in system 1800. Memory subsystem 1860 can include nonvolatile (state does not change if power to the memory device is interrupted) or volatile (state is indeterminate if power to the memory device is interrupted) memory devices, or a combination. Memory 1860 can store application data, user data, music, photos, documents, or other data, as well as system data (whether longterm or temporary) related to the execution of the applications and functions of system 1800. In one example, memory subsystem 1860 includes memory controller 1864 (which could also be considered part of the control of system 1800, and could potentially be considered part of processor 1810). Memory controller 1864 includes a scheduler to generate and issue commands to control access to memory device 1862.

Connectivity 1870 includes hardware devices (e.g., wireless or wired connectors and communication hardware, or a combination of wired and wireless hardware) and software components (e.g., drivers, protocol stacks) to enable system 1800 to communicate with external devices. The external device could be separate devices, such as other computing devices, wireless access points or base stations, as well as peripherals such as headsets, printers, or other devices. In one example, system 1800 exchanges data with an external device for storage in memory or for display on a display device. The exchanged data can include data to be stored in memory, or data already stored in memory, to read, write, or edit data.

Connectivity 1870 can include multiple different types of connectivity. To generalize, system 1800 is illustrated with cellular connectivity 1872 and wireless connectivity 1874. Cellular connectivity 1872 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution-also referred to as "4G"), or other cellular service standards. Wireless connectivity 1874 refers to wireless connectivity that is not cellular, and can include personal area networks (such as Bluetooth), local area networks (such as WiFi), or wide area networks (such as WiMax), or other wireless communication, or a combination. Wireless communication refers to transfer of data through the use of modulated electromagnetic radiation through a non-solid medium. Wired communication occurs through a solid communication medium.

Peripheral connections 1880 include hardware interfaces and connectors, as well as software components (e.g., drivers, protocol stacks) to make peripheral connections. It will be understood that system 1800 could both be a peripheral device ("to" 1882) to other computing devices, as well as have peripheral devices ("from" 1884) connected to it. System 1800 commonly has a "docking" connector to connect to other computing devices for purposes such as managing (e.g., downloading, uploading, changing, synchronizing) content on system 1800. Additionally, a docking connector can allow system 1800 to connect to certain peripherals that allow system 1800 to control content output, for example, to audiovisual or other systems.

In addition to a proprietary docking connector or other proprietary connection hardware, system 1800 can make peripheral connections 1880 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), or other type.

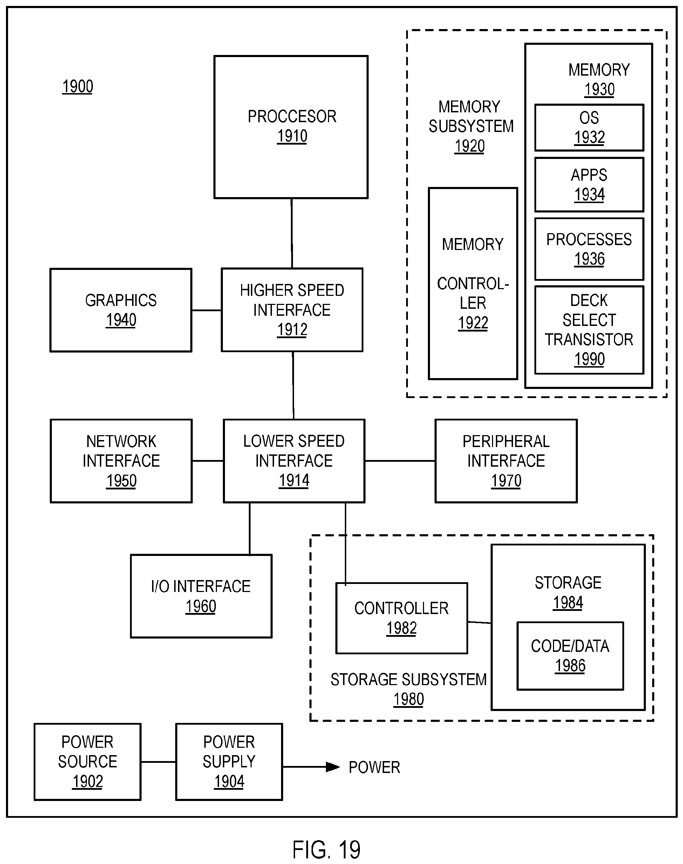

**Figure 19** is a block diagram of an example of a computing system that includes a deck select transistor within a memory device structure to enable decoder transistor footprint scaling. System 1900 represents a computing device in accordance with any example herein, and can be a laptop computer, a desktop computer, a tablet computer, a server, a gaming or entertainment control system, embedded computing device, or other electronic device.

System 1900 includes a memory device structure in memory 1930, such as for example memory device structure 100 of **Figure 1****.** In one example, deck select transistors 1990 represent deck select transistors in accordance with any example provided herein. The deck select transistors 1990 enable memory 1930 to provide selection of a target cell within the memory device structure. The use of the described deck select transistors enables selection with lower energy usage as compared to traditional decoder transistors.

System 1900 includes processor 1910 can include any type of microprocessor, central processing unit (CPU), graphics processing unit (GPU), processing core, or other processing hardware, or a combination, to provide processing or execution of instructions for system 1900. Processor 1910 controls the overall operation of system 1900, and can be or include, one or more programmable general-purpose or special-purpose microprocessors, digital signal processors (DSPs), programmable controllers, application specific integrated circuits (ASICs), programmable logic devices (PLDs), or a combination of such devices.

In one example, system 1900 includes interface 1912 coupled to processor 1910, which can represent a higher speed interface or a high throughput interface for system components that need higher bandwidth connections, such as memory subsystem 1920 or graphics interface components 1940. Interface 1912 represents an interface circuit, which can be a standalone component or integrated onto a processor die. Interface 1912 can be integrated as a circuit onto the processor die or integrated as a component on a system on a chip. Where present, graphics interface 1940 interfaces to graphics components for providing a visual display to a user of system 1900. Graphics interface 1940 can be a standalone component or integrated onto the processor die or system on a chip. In one example, graphics interface 1940 can drive a high definition (HD) display that provides an output to a user. In one example, the display can include a touchscreen display. In one example, graphics interface 1940 generates a display based on data stored in memory 1930 or based on operations executed by processor 1910 or both.

Memory subsystem 1920 represents the main memory of system 1900 and provides storage for code to be executed by processor 1910, or data values to be used in executing a routine. Memory subsystem 1920 can include one or more memory devices 1930 such as readonly memory (ROM), flash memory, one or more varieties of random access memory (RAM) such as DRAM or other memory devices, or a combination of such devices. In some embodiments memory subsystem 1920 includes persistent memory (PMem) which may offer higher RAM capacity than traditional DRAM. PMem may operate in a persistent mode, i.e., utilizing non-volatile devices (e.g., RRAM, PCM, CBRAM etc.) integrated with selectors in a tier architecture, to store data without power applied to the memory subsystem 920 for nonvolatile data storage. In other embodiments, memory subsystem 1920 includes solid state drives (SSDs), residing in a NAND package for fast storage.

Memory 1930 stores and hosts, among other things, operating system (OS) 1932 to provide a software platform for execution of instructions in system 1900. Additionally, applications 1934 can execute on the software platform of OS 1932 from memory 1930. Applications 1934 represent programs that have their own operational logic to perform execution of one or more functions. Processes 1936 represent agents or routines that provide auxiliary functions to OS 1932 or one or more applications 1934 or a combination. OS 1932, applications 1934, and processes 1936 provide software logic to provide functions for system 1900. In one example, memory subsystem 1920 includes memory controller 1922, which is a memory controller to generate and issue commands to memory 1930. It will be understood that memory controller 1922 could be a physical part of processor 1910 or a physical part of interface 1912. For example, memory controller 1922 can be an integrated memory controller, integrated onto a circuit with processor 1910, such as integrated onto the processor die or a system on a chip.

While not specifically illustrated, it will be understood that system 1900 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 1900 includes interface 1914, which can be coupled to interface 1912. Interface 1914 can be a lower speed interface than interface 1912. In one example, interface 1914 represents an interface circuit, which can include standalone components and integrated circuitry. In one example, multiple user interface components or peripheral components, or both, couple to interface 1914. Network interface 1950 provides system 1900 the ability to communicate with remote devices (e.g., servers or other computing devices) over one or more networks. Network interface 1950 can include an Ethernet adapter, wireless interconnection components, cellular network interconnection components, USB (universal serial bus), or other wired or wireless standards-based or proprietary interfaces. Network interface 1950 can exchange data with a remote device, which can include sending data stored in memory or receiving data to be stored in memory.

In one example, system 1900 includes one or more input/output (I/O) interface(s) 1960. I/O interface 1960 can include one or more interface components through which a user interacts with system 1900 (e.g., audio, alphanumeric, tactile/touch, or other interfacing). Peripheral interface 1970 can include any hardware interface not specifically mentioned above. Peripherals refer generally to devices that connect dependently to system 1900. A dependent connection is one where system 1900 provides the software platform or hardware platform or both on which operation executes, and with which a user interacts.

In one example, system 1900 includes storage subsystem 1980 to store data in a nonvolatile manner. In one example, in certain system implementations, at least certain components of storage 1980 can overlap with components of memory subsystem 1920. Storage subsystem 1980 includes storage device(s) 1984, which can be or include any conventional medium for storing large amounts of data in a nonvolatile manner, such as one or more magnetic, solid state, or optical based disks, or a combination. Storage 1984 holds code or instructions and data 1986 in a persistent state (i.e., the value is retained despite interruption of power to system 1900). Storage 1984 can be generically considered to be a "memory," although memory 1930 is typically the executing or operating memory to provide instructions to processor 1910. Whereas storage 1984 is nonvolatile, memory 1930 can include volatile memory (i.e., the value or state of the data is indeterminate if power is interrupted to system 1900). In one example, storage subsystem 1980 includes controller 1982 to interface with storage 1984. In one example controller 1982 is a physical part of interface 1914 or processor 1910 or can include circuits or logic in both processor 1910 and interface 1914.

Power source 1902 provides power to the components of system 1900. More specifically, power source 1902 typically interfaces to one or multiple power supplies 1904 in system 1902 to provide power to the components of system 1900. In one example, power supply 1904 includes an AC to DC (alternating current to direct current) adapter to plug into a wall outlet. Such AC power can be renewable energy (e.g., solar power) power source 1902. In one example, power source 1902 includes a DC power source, such as an external AC to DC converter. In one example, power source 1902 or power supply 1904 includes wireless charging hardware to charge via proximity to a charging field. In one example, power source 1902 can include an internal battery or fuel cell source.

## Claims

1. A memory device structure (100) comprising:
a first deck (128), wherein the first deck (128) comprises:
a first plurality of line structures (102), wherein individual ones of the first plurality of line structures (102) each comprise a first transistor channel (108, 110);
a second plurality of line structures (112) substantially orthogonal to the first plurality of line structures (102), wherein individual ones of the second plurality of line structures (112) each comprise a second transistor channel (118, 120); and
a memory cell (122, 124, 126) at each cross-point between the first plurality of line structures (102) and the second plurality of line structures (112); and
a second deck (130) above or below the first deck (128), wherein the second deck (130) comprises:
a third plurality of line structures (132) substantially parallel to the first plurality of line structures (102), wherein individual ones of the third plurality of line structures (132) each comprise a third transistor channel (138, 140);
a fourth plurality of line structures (142) substantially parallel to the second plurality of line structures (112), wherein individual ones of the fourth plurality of line structures (142) each comprise a fourth transistor channel (148, 150); and
a memory cell (152, 153, 164)
at each cross-point between the third plurality of line structures (132) and the fourth plurality of line structures (142),
**characterised in that** the memory device structure (100) further comprises a plurality of terminal interconnects (155, 156) between the first deck (128) and the second deck (130), wherein individual ones of the plurality of terminal interconnects (155, 156) are coupled between the individual ones of the line structures (102), (112) in the first deck (128) and corresponding individual ones of the line structures (132), (142) in the second deck (130); and
wherein individual ones of the transistor channels (108, 110, 118, 120) are between individual ones of the terminal interconnects (155, 156) and the memory cells (122, 124, 126, 152, 153).

2. The memory device structure (100) of claim 1, wherein the first, second, third and fourth plurality of line structures (102, 112, 132, 142) each comprise tungsten, tantalum or titanium or an alloy thereof further comprising nitrogen.

3. The memory device structure (100) of any one of claims 1-2, wherein the first, second, third and fourth transistor channels (108, 110, 118, 120, 138, 140, 148, 150) each comprise a polycrystalline or amorphous material.

4. The device structure (100) of claim 3, wherein the polycrystalline or amorphous material comprises In₂O₃, Ga₂O₃, ZnO, InGaZnO, InZnO, InGaO, GaZnO, InAlO, InSnO, InMgO, InWO, GaZnMgO, GaZnSnO, GaAlZnO, GaAlSnO, HfZnO, HfInZnO, HfAlGaZnO, InMgZnO, CuOₓ, NbO, NiO, CoO, SnO, Cu₂O, AgAlO, CuAlO₃, AlScOC, Sr₃BPO₃, La₂SiO₄Se, LaCuSe, Rb₂Sn₂O₃, La₂O₂S₂, K₂Sn₂O₃, Na₂FeOSe₂ or ZnRh₂O₄.

5. The memory device structure (100) of any one of claims 1-3, wherein individual ones of the first plurality of line structures (102), the second plurality of line structures (112), the third plurality of line structures (132) and the fourth plurality of line structures (142) comprise:
a first portion and a second portion, wherein each of the first portion and the second portion comprises a metal;
a third portion between the first portion and the second portion, wherein the third portion comprises the metal and oxygen; and
wherein each of the corresponding transistor channel is adjacent to a sidewall of the third portion.

6. The memory device structure (100) of claim 5, wherein the transistor channel clads the third portion.

7. The memory device structure (100) of claim 6, wherein the transistor channel extends above an uppermost surface and below a lowermost surface of the first portion or the second portion.

8. The memory device structure (100) of claim 7, wherein the third portion has a height that is greater than a height of the first portion or a height of the second portion.

9. The memory device structure (100) of any one of claims 1-8, wherein individual ones of the first plurality of line structures (102), the second plurality of line structures (112), the third plurality of line structures (132) and the fourth plurality of line structures (142) comprise:
a first portion and a second portion each comprising a metal; and
a third portion between the first portion and the second portion, wherein the third portion comprises a material of the transistor channel.

10. The memory device structure (100) of any one of claims 1-8, wherein individual ones of the transistor channels (108, 110, 118, 120, 138, 140, 148, 150) in the first plurality of line structures (102), the second plurality of line structures (112), the third plurality of line structures (132) and the fourth plurality of line structures (142) are coupled in electrical parallel through a gate structure (166, 168, 170, 172, 174; 202; 302, 304; 402).

11. The memory device structure (100) of any one of claims 1-10, further comprising a memory cell at each cross-point between the first plurality of line structures (102) and the fourth plurality of line structures (142).

12. The memory device structure of any one of claims 1-11, wherein each memory cell (122, 124, 126, 152, 153, 164) comprises a nonvolatile memory element (510) coupled with a selector element (508).

13. A system (1800; 1900) comprising:
a processor (1810; 1910); and
a memory (1862; 1930) comprising a memory device structure (100) of any one of claims 1 to 12.

14. The system of claim 13, further comprising a memory controller (1864; 1922) coupled with the memory (1862; 1930).

## Patentansprüche

1. Speichervorrichtungsstruktur (100), die Folgendes umfasst:
ein erstes Deck (128), wobei das erste Deck (128) Folgendes umfasst:
eine erste Mehrzahl von Leitungsstrukturen (102), wobei einzelne der ersten Mehrzahl von Leitungsstrukturen (102) jeweils einen ersten Transistorkanal (108, 110) umfassen;
eine zweite Mehrzahl von Leitungsstrukturen (112), die im Wesentlichen orthogonal zu der ersten Mehrzahl von Leitungsstrukturen (102) sind, wobei einzelne der zweiten Mehrzahl von Leitungsstrukturen (112) jeweils einen zweiten Transistorkanal (118, 120) umfassen; und
Eine Speicherzelle (122, 124, 126) an jedem Kreuzungspunkt zwischen der ersten Mehrzahl von Leitungsstrukturen (102) und der zweiten Mehrzahl von Leitungsstrukturen (112); und
ein zweites Deck (130) über oder unter dem ersten Deck (128), wobei das zweite Deck (130) Folgendes umfasst:
eine dritte Mehrzahl von Leitungsstrukturen (132), die im Wesentlichen parallel zu der ersten Mehrzahl von Leitungsstrukturen (102) sind, wobei einzelne der dritten Mehrzahl von Leitungsstrukturen (132) jeweils einen dritten Transistorkanal (138, 140) umfassen;
eine vierte Mehrzahl von Leitungsstrukturen (142), die im Wesentlichen parallel zu der zweiten Mehrzahl von Leitungsstrukturen (112) sind, wobei einzelne der vierten Mehrzahl von Leitungsstrukturen (142) jeweils einen vierten Transistorkanal (148, 150) umfassen; und
eine Speicherzelle (152, 153, 164) an jedem Kreuzungspunkt zwischen der dritten Mehrzahl von Leitungsstrukturen (132) und der vierten Mehrzahl von Leitungsstrukturen (142),
**dadurch gekennzeichnet, dass**
die Speichervorrichtungsstruktur (100) ferner eine Mehrzahl von Anschlusszwischenverbindungen (155, 156) zwischen dem ersten Deck (128) und dem zweiten Deck (130) umfasst, wobei einzelne der Mehrzahl von Anschlusszwischenverbindungen (155, 156) zwischen die einzelnen der Leitungsstrukturen (102), (112) in dem ersten Deck (128) und entsprechenden einzelnen der Leitungsstrukturen (132), (142) in dem zweiten Deck (130) gekoppelt sind; und
wobei sich einzelne der Transistorkanäle (108, 110, 118, 120) zwischen einzelnen der Anschlusszwischenverbindungen (155, 156) und den Speicherzellen (122, 124, 126, 152, 153) befinden.

2. Speichervorrichtungsstruktur (100) nach Anspruch 1, wobei die erste, zweite, dritte und vierte Mehrzahl von Leitungsstrukturen (102, 112, 132, 142) jeweils Wolfram, Tantal oder Titan oder eine Legierung davon umfassen, die ferner Stickstoff umfasst.

3. Speichervorrichtungsstruktur (100) nach einem der Ansprüche 1-2, wobei der erste, zweite, dritte und vierte Transistorkanal (108, 110, 118, 120, 138, 140, 148, 150) jeweils ein polykristallines oder amorphes Material umfassen.

4. Vorrichtungsstruktur (100) nach Anspruch 3, wobei das polykristalline oder amorphe Material In₂O₃, Ga₂O₃, ZnO, InGaZnO, InZnO, InGaO, GaZnO, InAlO, InSnO, InMgO, InWO, GaZnMgO, GaZnSnO, GaAlZnO, GaAlSnO, HfZnO, HfInZnO, HfAlGaZnO, InMgZnO, CuOₓ, NbO, NiO, CoO, SnO, Cu₂O, AgAlO, CuAlO₃, AlScOC, Sr₃BPO₃, La₂SiO₄Se, LaCuSe, Rb₂Sn₂O₃, La₂O₂S₂, K₂Sn₂O₃, Na₂FeOSe₂ oder ZnRh₂O₄ umfassen.

5. Speichervorrichtungsstruktur (100) nach einem der Ansprüche 1-3, wobei einzelne der ersten Mehrzahl von Leitungsstrukturen (102), der zweiten Mehrzahl von Leitungsstrukturen (112), der dritten Mehrzahl von Leitungsstrukturen (132) und der vierten Mehrzahl von Leitungsstrukturen (142) Folgendes umfassen:
einen ersten Teil und einen zweiten Teil, wobei sowohl der erste Teil als auch der zweite Teil ein Metall umfassen;
einen dritten Teil zwischen dem ersten Teil und dem zweiten Teil, wobei der dritte Teil das Metall und Sauerstoff umfasst; und
wobei jeder des entsprechenden Transistorkanals an eine Seitenwand des dritten Teils angrenzt.

6. Speichervorrichtungsstruktur (100) nach Anspruch 5, wobei der Transistorkanal den dritten Teil bedeckt.

7. Speichervorrichtungsstruktur (100) nach Anspruch 6, wobei sich der Transistorkanal über eine oberste Oberfläche und unter eine unterste Oberfläche des ersten Teils oder des zweiten Teils erstreckt.

8. Speichervorrichtungsstruktur (100) nach Anspruch 7, wobei der dritte Teil eine Höhe aufweist, die größer als eine Höhe des ersten Teils oder eine Höhe des zweiten Teils ist.

9. Speichervorrichtungsstruktur (100) nach einem der Ansprüche 1-8, wobei einzelne der ersten Mehrzahl von Leitungsstrukturen (102), der zweiten Mehrzahl von Leitungsstrukturen (112), der dritten Mehrzahl von Leitungsstrukturen (132) und der vierten Mehrzahl von Leitungsstrukturen (142) Folgendes umfassen:
einen ersten Teil und einen zweiten Teil, die jeweils ein Metall umfassen; und
einen dritten Teil zwischen dem ersten Teil und dem zweiten Teil, wobei der dritte Teil ein Material des Transistorkanals umfasst.

10. Speichervorrichtungsstruktur (100) nach einem der Ansprüche 1-8, wobei einzelne der Transistorkanäle (108, 110, 118, 120, 138, 140, 148, 150) in der ersten Mehrzahl von Leitungsstrukturen (102), der zweiten Mehrzahl von Leitungsstrukturen (112), der dritten Mehrzahl von Leitungsstrukturen (132) und der vierten Mehrzahl von Leitungsstrukturen (142) durch eine Gate-Struktur (166, 168, 170, 172, 174; 202; 302, 304; 402) elektrisch parallel gekoppelt sind.

11. Speichervorrichtungsstruktur (100) nach einem der Ansprüche 1-10, die ferner eine Speicherzelle an jedem Kreuzungspunkt zwischen der ersten Mehrzahl von Leitungsstrukturen (102) und der vierten Mehrzahl von Leitungsstrukturen (142) umfasst.

12. Speichervorrichtungsstruktur nach einem der Ansprüche 1-11, wobei jede Speicherzelle (122, 124, 126, 152, 153, 164) ein nichtflüchtiges Speicherelement (510) umfasst, das mit einem Auswahlelement (508) gekoppelt ist.

13. System (1800; 1900), das Folgendes umfasst:
einen Prozessor (1810; 1910); und
einen Speicher (1862; 1930), der eine Speichervorrichtungsstruktur (100) nach einem der Ansprüche 1 bis 12 umfasst.

14. System nach Anspruch 13, das ferner eine Speichersteuerung (1864; 1922) umfasst, die mit dem Speicher (1862; 1930) gekoppelt ist.

## Revendications

1. Structure de dispositif de mémoire (100) comprenant :
un premier plan (128), le premier plan (128) comprenant
une première pluralité de structures de lignes (102), où des structures individuelles de la première pluralité de structures de lignes (102) comprennent chacune un premier canal de transistor (108, 110) ;
une deuxième pluralité de structures de lignes (112) sensiblement orthogonales à la première pluralité de structures de lignes (102), où des structures individuelles de la deuxième pluralité de structures de lignes (112) comprennent chacune un deuxième canal de transistor (118, 120) ; et
une cellule de mémoire (122, 124, 126) à chaque point de croisement entre la première pluralité de structures de lignes (102) et la deuxième pluralité de structures de lignes (112) ; et
un deuxième plan (130) au-dessus ou en dessous du premier plan (128), où le deuxième plan (130) comprend :
une troisième pluralité de structures de lignes (132) sensiblement parallèles à la première pluralité de structures de lignes (102), où les structures individuelles de la troisième pluralité de structures de lignes (132) comprennent chacune un troisième canal de transistor (138, 140) ;
une quatrième pluralité de structures de lignes (142) sensiblement parallèles à la deuxième pluralité de structures de lignes (112), où des structures individuelles de la quatrième pluralité de structures de lignes (142) comprennent chacune un quatrième canal de transistor (148, 150) ; et
une cellule de mémoire (152, 153, 164) à chaque point de croisement entre la troisième pluralité de structures de lignes (132) et la quatrième pluralité de structures de lignes (142),
**caractérisé en ce que**
la structure de dispositif de mémoire (100) comprend en outre une pluralité d'interconnexions de bornes (155, 156) entre le premier plan (128) et le deuxième plan (130), où des interconnexions individuelles parmi la pluralité d'interconnexions de bornes (155, 156) sont couplées entre les structures de lignes individuelles (102), (112) dans le premier plan (128) et les structures de lignes individuelles correspondantes (132), (142) dans le deuxième plan (130) ; et
où des canaux individuels des canaux de transistors (108, 110, 118, 120) sont situés entre des interconnexions individuelles des interconnexions de bornes (155, 156) et les cellules de mémoire (122, 124, 126, 152, 153).

2. Structure de dispositif de mémoire (100) selon la revendication 1, dans laquelle les première, deuxième, troisième et quatrième pluralités de structures de lignes (102, 112, 132, 142) comprennent chacune du tungstène, du tantale ou du titane ou un alliage de ceux-ci comprenant en outre de l'azote.

3. Structure de dispositif de mémoire (100) selon l'une quelconque des revendications 1 et 2, dans laquelle les premier, deuxième, troisième et quatrième canaux de transistor (108, 110, 118, 120, 138, 140, 148, 150) comprennent chacun un matériau polycristallin ou amorphe.

4. Structure de dispositif (100) selon la revendication 3, dans laquelle le matériau polycristallin ou amorphe comprend les matériaux suivants : In₂O₃, Ga₂O₃, ZnO, InGaZnO, InZnO, InGaO, GaZnO, InAlO, InSnO, InMgO, InWO, GaZnMgO, GaZnSnO, GaAlZnO, GaAlSnO, HfZnO, HfInZnO, HfAlGaZnO, InMgZnO, CuOₓ, NbO, NiO, CoO, SnO, Cu₂O, AgAlO, CuAlO₃, AlScOC, Sr₃BPO₃, La₂SiO₄Se, LaCuSe, Rb₂Sn₂O₃, La₂O₂S₂, K₂Sn₂O₃, Na₂FeOSe₂ ou ZnRh₂O₄.

5. Structure de dispositif de mémoire (100) selon l'une quelconque des revendications 1 à 3, dans laquelle des structures individuelles parmi la première pluralité de structures de lignes (102), la deuxième pluralité de structures de lignes (112), la troisième pluralité de structures de lignes (132) et la quatrième pluralité de structures de lignes (142) comprennent :
une première partie et une deuxième partie, chacune de la première partie et de la deuxième partie comprenant un métal ;
une troisième partie entre la première partie et la deuxième partie, où la troisième partie comprend le métal et l'oxygène ; et
dans laquelle chacun des canaux de transistor correspondants est adjacent à une paroi latérale de la troisième partie.

6. Structure de dispositif de mémoire (100) selon la revendication 5, dans laquelle le canal de transistor recouvre la troisième partie.

7. Structure de dispositif de mémoire (100) selon la revendication 6, dans laquelle le canal du transistor s'étend au-dessus de la surface la plus haute et en dessous de la surface la plus basse de la première partie ou de la deuxième partie.

8. Structure de dispositif de mémoire (100) selon la revendication 7, dans laquelle la troisième partie a une hauteur qui est supérieure à la hauteur de la première partie ou à la hauteur de la deuxième partie.

9. Structure de dispositif de mémoire (100) selon l'une quelconque des revendications 1 à 8, dans laquelle des structures individuelles parmi la première pluralité de structures de lignes (102), la deuxième pluralité de structures de lignes (112), la troisième pluralité de structures de lignes (132) et la quatrième pluralité de structures de lignes (142) comprennent :
une première partie et une deuxième partie comprenant chacune un métal ; et
une troisième partie entre la première partie et la deuxième partie, où la troisième partie comprend un matériau du canal de transistor.

10. Structure de dispositif de mémoire (100) selon l'une quelconque des revendications 1 à 8, dans laquelle des canaux individuels des canaux de transistor (108, 110, 118, 120, 138, 140, 148, 150) dans la première pluralité de structures de lignes (102), la deuxième pluralité de structures de lignes (112), la troisième pluralité de structures de lignes (132) et la quatrième pluralité de structures de lignes (142) sont couplés électriquement en parallèle par une structure de grille (166, 168, 170, 172, 174 ; 202 ; 302, 304 ; 402).

11. Structure de dispositif de mémoire (100) selon l'une quelconque des revendications 1 à 10, comprenant en outre une cellule de mémoire à chaque point de croisement entre la première pluralité de structures de lignes (102) et la quatrième pluralité de structures de lignes (142).

12. Structure de dispositif de mémoire selon l'une quelconque des revendications 1 à 11, dans laquelle chaque cellule de mémoire (122, 124, 126, 152, 153, 164) comprend un élément de mémoire non volatile (510) couplé à un élément de sélection (508).

13. Système (1800 ; 1900) comprenant :
un processeur (1810 ; 1910) ; et
une mémoire (1862 ; 1930) comprenant une structure de dispositif de mémoire (100) selon l'une quelconque des revendications 1 à 12.

14. Système selon la revendication 13, comprenant en outre un contrôleur de mémoire (1864 ; 1922) couplé à la mémoire (1862 ; 1930).
